# EUROPÄISCHE PATENTANMELDUNG

(11) **EP 3 747 653 A1**
(43) Veröffentlichungstag der Anmeldung: **09.12.2020**
(21) Anmeldenummer: 20172076.0
(22) Anmeldetag: 29.04.2020
(51) Int. Cl.: B41F 23/04

(54) **VORRICHTUNG FÜR EINE LICHTQUELLE EINER DRUCKMASCHINE MIT EINER VIELZAHL VON LICHTEMITTIERENDEN HALBLEITERBAUELEMENTEN EINER ERSTEN ART UND MINDESTENS EINEM LICHTEMITTIERENDEN HALBLEITERBAUELEMENT EINER WEITEREN ART AUF EINEM SUBSTRAT**

(30) Priorität: 06.06.2019 DE 102019208308
(71) Anmelder: Heraeus Noblelight GmbH, 63450 Hanau (DE)
(72) Erfinder: Stahl, Andreas, 60599 Frankfurt am Main (DE)
(74) Vertreter: Herzog IP Patentanwalts GmbH

(57) **Zusammenfassung**

Die Erfindung betrifft eine Vorrichtung (100), beinhaltend
a) ein Substrat (101), und
b) eine auf dem Substrat (101) angeordnete elektrische Schaltung (102), beinhaltend einen ersten Abschnitt (201), beinhaltend
i) eine erste Vielzahl von lichtemittierenden Halbleiterbauelementen, beinhaltend
A) eine Vielzahl von lichtemittierenden Halbleiterbauelementen einer ersten Art (103), und
B) mindestens ein lichtemittierendes Halbleiterbauelement einer weiteren Art (104), und
ii) eine erste Vielzahl von parallel zueinander geschalteten Parallelschaltpfaden (105); wobei jeder der Parallelschaltpfade (105) der ersten Vielzahl von Parallelschaltpfaden (105)
a. ein erstes Ende (106), und
b. ein gegenüberliegendes weiteres Ende (107) beinhaltet; wobei die ersten Enden (106) der Parallelschaltpfade (105) der ersten Vielzahl von Parallelschaltpfaden (105) miteinander elektrisch leitend verbunden sind; wobei die weiteren Enden (107) der Parallelschaltpfade (105) der ersten Vielzahl von Parallelschaltpfaden (105) elektrisch leitend miteinander verbunden sind; wobei jedes lichtemittierende Halbleiterbauelement der ersten Art (103) dazu angeordnet und ausgebildet ist, bei einem Anliegen einer Betriebsspannung des lichtemittierenden Halbleiterbauelements der ersten Art (103) Licht mit einem Spektrum, beinhaltend ein lokales Intensitätsmaximum in einem ersten Wellenlängenbereich, abzustrahlen, wobei jedes lichtemittierende Halbleiterbauelement der weiteren Art (104) dazu angeordnet und ausgebildet ist, bei einem Anliegen einer Betriebsspannung des lichtemittierenden Halbleiterbauelements der weiteren Art (104) Licht mit einem Spektrum, beinhaltend ein lokales Intensitätsmaximum in einem von dem ersten Wellenlängenbereich verschiedenen weiteren Wellenlängenbereich abzustrahlen;

wobei mindestens einer der Parallelschaltpfade (105) der ersten Vielzahl von Parallelschaltpfaden (105) ein lichtemittierendes Halbleiterbauelement der weiteren Art (104) beinhaltet;
wobei jeder Parallelschaltpfad (105) der ersten Vielzahl von Parallelschaltpfaden (105) eine Betriebsspannungssumme aufweist, die eine Summe der Betriebsspannungen der lichtemittierenden Halbleiterbauelemente in dem jeweiligen Parallelschaltpfad (105) ist;
wobei keine Betriebsspannungssumme der Parallelschaltpfade (105) der ersten Vielzahl von Parallelschaltpfaden (105) um mehr als 0,6 V von einer Betriebsspannungssumme der Parallelschaltpfade (105) der ersten Vielzahl von Parallelschaltpfaden (105) abweicht.

## Beschreibung

Die vorliegende Erfindung betrifft eine Vorrichtung, beinhaltend
a) ein Substrat, und
b) eine auf dem Substrat angeordnete elektrische Schaltung, beinhaltend einen ersten Abschnitt, beinhaltend
   i) eine erste Vielzahl von lichtemittierenden Halbleiterbauelementen, beinhaltend
      A) eine Vielzahl von lichtemittierenden Halbleiterbauelementen einer ersten Art, und
      B) mindestens ein lichtemittierendes Halbleiterbauelement einer weiteren Art, und
   ii) eine erste Vielzahl von parallel zueinander geschalteten Parallelschaltpfaden;
wobei jeder der Parallelschaltpfade der ersten Vielzahl von Parallelschaltpfaden
a. ein erstes Ende, und
b. ein gegenüberliegendes weiteres Ende
beinhaltet; wobei die ersten Enden der Parallelschaltpfade der ersten Vielzahl von Parallelschaltpfaden miteinander elektrisch leitend verbunden sind; wobei die weiteren Enden der Parallelschaltpfade der ersten Vielzahl von Parallelschaltpfaden elektrisch leitend miteinander verbunden sind; wobei jedes lichtemittierende Halbleiterbauelement der ersten Art dazu angeordnet und ausgebildet ist, bei einem Anliegen einer Betriebsspannung des lichtemittierende Halbleiterbauelements der ersten Art Licht mit einem Spektrum, beinhaltend ein lokales Intensitätsmaximum in einem ersten Wellenlängenbereich, abzustrahlen, wobei jedes lichtemittierende Halbleiterbauelement der weiteren Art dazu angeordnet und ausgebildet ist, bei einem Anliegen einer Betriebsspannung des lichtemittierende Halbleiterbauelements der weiteren Art Licht mit einem Spektrum, beinhaltend ein lokales Intensitätsmaximum in einem von dem ersten Wellenlängenbereich verschiedenen weiteren Wellenlängenbereich abzustrahlen; wobei mindestens einer der Parallelschaltpfade der ersten Vielzahl von Parallelschaltpfaden ein lichtemittierendes Halbleiterbauelementen der weiteren Art beinhaltet; wobei jeder Parallelschaltpfad der ersten Vielzahl von Parallelschaltpfaden gekennzeichnet ist durch eine Betriebsspannungssumme, die eine Summe der Betriebsspannungen der lichtemittierenden Halbleiterbauelemente in dem jeweiligen Parallelschaltpfad ist; dadurch gekennzeichnet, dass keine Betriebsspannungssumme der Parallelschaltpfade der ersten Vielzahl von Parallelschaltpfaden um mehr als 0,6 V von einer Betriebsspannungssumme der Parallelschaltpfade der ersten Vielzahl von Parallelschaltpfaden abweicht. Ferner betrifft die Erfindung eine Lichtquelle; eine Druckmaschine; Verfahren, insbesondere zum Herstellen eines Druckerzeugnisses und zum Bestrahlen eines Bestrahlungsguts; ein Druckerzeugnis; eine Anordnung mit der erfindungsgemäßen Lichtquelle; und Verwendungen der erfindungsgemäßen Lichtquelle.

Im technischen Gebiet der Erfindung - der Druckindustrie - ist die Verwendung von Lichtquellen zum Aushärten von Druckfarben und Lacken seit Langem bekannt. Ferner ist die Verwendung von UV-härtbaren Farben und Lacken - also Farben und Lacken, die durch Bestrahlen mit geeigneter ultravioletter Strahlung gehärtet werden können - bekannt. Herkömmlicherweise werden zum Härten solcher Farben und Lacke Quecksilberdampflampen eingesetzt. Diese Lichtquellen zeigen jedoch beispielsweise hinschlich ihrer Lebensdauer, Wartungsintensität und auch Wärmeentwicklung erhebliche Nachteile. Dies wurde im Stand der Technik bereits erkannt. In der Folge werden immer häufiger lichtemittierende Halbleiterbauelemente, insbesondere Leuchtdioden-Module (LED-Module), an Stelle von Quecksilberdampflampen zum Bestrahlen UV-härtbarer Farben und Lacke eingesetzt. Obgleich die Verwendung von Leuchtdioden bereits viele Vorteile gegenüber den altbekannten Quecksilberdampflampen eröffnet, besteht für die Ausgestaltung von Lichtquellen mit LED, insbesondere aber nicht ausschließlich mit UV-LED, Raum zur Verbesserung.

Funktionsbedingt weisen lichtemittierende Halbleiterbauelemente wie LED ein gegenüber herkömmlichen Lichtquellen wie Quecksilberdampflampen engeres Emissionsspektrum auf. Zum Härten von Farben und Lacken müssen diese oftmals mit Licht, insbesondre UV-Licht, eines bestimmten Spektrums bestrahlt werden. Da dieses Spektrum von der jeweiligen Farbe oder dem Lack abhängt, sind Leuchten mit LED gleichen Spektrums in der Anwendung wenig flexibel. Ferner können Farben und Lacke ein Spektrum, welches eine Kombination von bestimmten Wellenlängen enthält, oder ein Spektrum, das sich möglichst gleichförmig über einen vorbestimmten Bereich erstreckt, erfordern. Um den vorgenannten Fällen auf möglichst flexible Weise Rechnung zu tragen, muss eine LED-Leuchte eine Vielzahl von LED-Typen mit verschiedenen Emissionsspektren beinhalten. Hierzu wird im Stand der Technik eine Kombination aus mehreren LED-Module verwendet, wobei jedes der Module LED eines Typs beiträgt. Diese Lösung hat erhebliche Nachteile. Soll die LED-Leuchte möglichst flexibel einsetzbar sein oder ein möglichst breites Spektrum zur Verfügung stellen, muss sie viele verschiedene LED-Module beinhalten. Es ergibt sich eine Dualität zwischen den Anforderungen an das Emissionsspektrum der Leuchte und einer möglichst kompakten Bauform. Letztere ist gerade für den Einsatz in Druckmaschinen erstrebenswert. Ferner weist eine Intensitätsverteilung einer Leuchte mit mehreren LED-Modulen oftmals Streifen oder Stufen auf, wodurch eine homogene Beleuchtung größerer Flächen erschwert wird. Beim Aushärten großflächiger Farb- und Lackaufträge kann es in der Folge zu Inhomogenitäten und damit Qualitätseinbußen kommen. Gegen eine Kombination mehrerer LED unterschiedlichen Typs in einem LED-Modul spricht insbesondere, dass LED unterschiedlichen Typs oftmals unterschiedliche Betriebsspannungen haben. Ein LED-Modul ist jedoch oftmals für eine bestimmte Betriebsspannung ausgelegt, so dass es auf einen LED-Typ festgelegt ist. Selbst wenn man Spannungsversorgung und Schaltung eines LED-Moduls so aufeinander abstimmen würde, dass an jeder LED des Moduls eine vorbestimmte Betriebsspannung abfällt, wäre ein solches LED-Modul grundsätzlich sehr fehleranfällig. Im schlimmsten Fall kann der Ausfall einer einzigen LED zum Ausfall des gesamten Moduls führen. Deshalb wurde diese Lösung bisher nicht in Betracht gezogen.

Allgemein ist es eine Aufgabe der vorliegenden Erfindung, einen Nachteil, der sich aus dem Stand der Technik ergibt, zumindest teilweise zu überwinden.

Eine weitere Aufgabe der Erfindung ist es, eine Lichtquelle für eine Druckmaschine bereitzustellen, die sich zu einem räumlich möglichst homogenen Aushärten möglichst vieler verschiedener Druckfarben und Lacke, insbesondere UV-härtbaren Druckfarben und Lacken, durch Bestrahlen mit Licht aus lichtemittierenden Halbleiterbauelementen, insbesondere Leuchtioden, eignet. Hierzu kann die Lichtquelle insbesondere ein Emissionsspektrum mit Intensitätsmaxima bei verschiedenen Wellenlängen oder ein möglichst breites Emissionsspektrum aufweisen. Ferner wird das räumlich möglichst homogenen Aushärten insbesondere durch ein Verringern oder Vermeiden von Streifen und/oder Stufen in einer Intensitätsverteilung auf einer die Druckfarbe oder den Lack aufweisenden Zielfläche einer Bestrahlung mit der Lichtquelle ermöglicht. Eine weitere Aufgabe der Erfindung ist es, die vorgenannte Lichtquelle bereitzustellen, wobei das vorgenannte Emissionsspektrum zumindest überwiegend im UV-Bereich liegt. Eine weitere Aufgabe der Erfindung ist es, eine Halbleiterlichtquelle bereitzustellen, deren Emissionsspektrum UV-A-Anteile mit UV-B- und/oder UV-C-Anteilen kombiniert. Weiter ist es eine Aufgabe der Erfindung, eine Halbleiterlichtquelle bereitzustellen, deren Emissionsspektrum möglichst den gesamten UV-A-Bereich abdeckt.

Ferner ist es eine Aufgabe der Erfindung, eine Lichtquelle für eine Druckmaschine bereitzustellen, die sich zu einem Aushärten möglichst vieler verschiedener Druckfarben und Lacke, insbesondere UV-härtbaren Druckfarben und Lacken, durch Bestrahlen mit Licht aus lichtemittierenden Halbleiterbauelementen, insbesondere Leuchtioden, eignet und dabei möglichst wenig störanfällig, insbesondere möglichst wenig anfällig für Ausfälle ist. In diesem Zusammenhang beeinträchtigen Defekte einzelner Halbleiterbauteile der Lichtquelle die Gesamtemission möglichst wenig. Eine weitere Aufgabe der Erfindung ist es, eine Lichtquelle für eine Druckmaschine bereitzustellen, die sich durch eine möglichst hohe Lebensdauer auszeichnet.

Eine weitere Aufgabe der Erfindung ist es, eine Lichtquelle möglichst kompakter Bauweise für eine Druckmaschine bereitzustellen. Ferner ist es eine Aufgabe der Erfindung, eine mit einem möglichst einfachen Verfahren und /oder einem Verfahren möglichst kurzer Verfahrensdauer herstellbare Lichtquelle für eine Druckmaschine bereitzustellen. Weiter ist es eine Aufgabe der Erfindung, eine Lichtquelle für eine Druckmaschine bereitzustellen, wobei sich die Lichtquelle durch eine vorteilhafte Balance aus kompakter Bauweise auf der einen Seite und Herstellbarkeit durch ein einfaches Verfahren und/oder ein Verfahren kurzer Verfahrensdauer auf der anderen Seite auszeichnet. Die vorstehende kompakte Bauweise wird vorzugsweise durch ein möglichst kleines Verhältnis einer Fläche eines Substrats zu einer Emissionsfläche der Lichtquelle erreicht.

Weiter ist eine Aufgabe der Erfindung, ein LED-Modul bereitzustellen, das in einer Lichtquelle zur Lösung einer der obigen Aufgaben beiträgt.

Eine weitere Aufgabe der Erfindung ist es, eine Lichtquelle für eine Druckmaschine bereitzustellen, wobei die Lichtquelle möglichst flexibel und mit möglichst geringem Aufwand an eine auszuhärtende Druckfarbe oder einen Lack, insbesondere eine UV-härtbare Druckfarbe oder Lack, angepasst werden kann. Ferner ist eine Aufgabe der Erfindung, LED-Module für das vorbeschriebene Anpassen der Lichtquelle bereitzustellen. Eine weitere Aufgabe der Erfindung ist es, ein LED-Modul zu einem möglichst wenig aufwendigen Nachrüsten einer bestehenden Lichtquelle für eine Druckmaschine bereitzustellen. Mit dem vorgenannten Nachrüsten kann die bestehende Lichtquelle vorzugsweise zum Lösen einer der oben beschriebenen Aufgaben verbessert werden.

Eine weitere Aufgabe der Erfindung ist es, eine Lichtquelle, bevorzugt eine UV-Lichtquelle, für eine Druckmaschine bereitzustellen, wobei sich die Lichtquelle durch eine erhöhte Lebensdauer auszeichnet. Diese Aufgabe wird bevorzugt dadurch gelöst, dass die Lichtquelle auf einem Substrat möglichst wenig Bauteile aufweist, die im Betrieb der Lichtquelle durch elektromagnetische Strahlung degradieren können, wie beispielsweise aktive oder passive elektrische Elemente (zum Beispiel ohmsche Widerstände, integrierte Schaltkreise etc.) unter Einstrahlung von UV-Licht.

Weiter ist es eine Aufgabe der Erfindung, eine der vorstehend beschriebenen vorteilhaften Lichtquellen beinhaltende Druckmaschine bereitzustellen. Demnach zeigt diese Druckmaschine vorzugsweise einen oder mehrere der vorstehend für die Lichtquelle beschriebenen Vorteile.

Ein Beitrag zur mindestens teilweisen Erfüllung mindestens einer, vorzugsweise mehrerer, der obigen Aufgaben wird durch die unabhängigen Ansprüche geleistet. Die abhängigen Ansprüche stellen bevorzugte Ausführungsformen bereit, die zur mindestens teilweisen Erfüllung mindestens einer der Aufgaben beitragen.

Einen Beitrag zur Erfüllung mindestens einer der erfindungsgemäßen Aufgaben leistet eine Ausführungsform 1 einer Vorrichtung, beinhaltend
a) ein Substrat, und
b) eine auf dem Substrat angeordnete elektrische Schaltung, beinhaltend einen ersten Abschnitt, beinhaltend
   i) eine erste Vielzahl von lichtemittierenden Halbleiterbauelementen, beinhaltend
      A) eine Vielzahl von lichtemittierenden Halbleiterbauelementen einer ersten Art, und
      B) mindestens ein lichtemittierendes Halbleiterbauelement einer weiteren Art, und
   ii) eine erste Vielzahl von parallel zueinander geschalteten Parallelschaltpfaden;
wobei jeder der Parallelschaltpfade der ersten Vielzahl von Parallelschaltpfaden
a. ein erstes Ende, und
b. ein, bevorzugt in einer Vorwärtsrichtung der lichtemittierenden Halbleiterbauelemente der ersten Vielzahl von lichtemittierenden Halbleiterbauelementen oder entgegen dieser Vorwärtsrichtung, gegenüberliegendes weiteres Ende
beinhaltet; wobei die ersten Enden der Parallelschaltpfade der ersten Vielzahl von Parallelschaltpfaden miteinander elektrisch leitend verbunden sind; wobei die weiteren Enden der Parallelschaltpfade der ersten Vielzahl von Parallelschaltpfaden elektrisch leitend miteinander verbunden sind; wobei jedes lichtemittierende Halbleiterbauelement der ersten Art dazu angeordnet und ausgebildet ist, bei einem Anliegen einer Betriebsspannung des lichtemittierende Halbleiterbauelements der ersten Art Licht mit einem Spektrum, beinhaltend ein lokales Intensitätsmaximum in einem ersten Wellenlängenbereich, abzustrahlen, wobei jedes lichtemittierende Halbleiterbauelement der weiteren Art dazu angeordnet und ausgebildet ist, bei einem Anliegen einer Betriebsspannung des lichtemittierende Halbleiterbauelements der weiteren Art Licht mit einem Spektrum, beinhaltend ein lokales Intensitätsmaximum in einem von dem ersten Wellenlängenbereich verschiedenen weiteren Wellenlängenbereich abzustrahlen; wobei mindestens einer der Parallelschaltpfade der ersten Vielzahl von Parallelschaltpfaden ein lichtemittierendes Halbleiterbauelementen der weiteren Art beinhaltet; wobei jeder Parallelschaltpfad der ersten Vielzahl von Parallelschaltpfaden gekennzeichnet ist durch eine Betriebsspannungssumme, die eine Summe der Betriebsspannungen der lichtemittierenden Halbleiterbauelemente in dem jeweiligen Parallelschaltpfad ist; dadurch gekennzeichnet, dass keine Betriebsspannungssumme der Parallelschaltpfade der ersten Vielzahl von Parallelschaltpfaden um mehr als 0,6 V, bevorzugt um mehr als 0,5 V, bevorzugter mehr als 0,4 V, bevorzugter mehr als 0,3 V, noch bevorzugter mehr als 0,2 V, am bevorzugtesten mehr als 0,1 V, von einer Betriebsspannungssumme der Parallelschaltpfade der ersten Vielzahl von Parallelschaltpfaden abweicht. Die erste Vielzahl von Parallelschaltpfaden beinhaltet mindestens 2, bevorzugt mindestens 3, bevorzugter mindestens 4, Parallelschaltpfade. Die Vielzahl von lichtemittierenden Halbleiterbauelementen der ersten Art beinhaltet mindestens 2, bevorzugt mindestens 4, bevorzugter mindestens 5, noch bevorzugter mindestens 8, lichtemittierenden Halbleiterbauelementen der ersten Art. Alternativ oder zusätzlich bevorzugt beinhaltet die Vielzahl von lichtemittierenden Halbleiterbauelementen der ersten Art mindestens doppelt so viele lichtemittierende Halbleiterbauelemente der ersten Art wie die erste Vielzahl von lichtemittierenden Halbleiterbauelementen solche der weiteren Art beinhaltet.

In einer erfindungsgemäßen Ausführungsform 2 ist die Vorrichtung nach ihrer Ausführungsform 1 ausgestaltet, wobei der erste Wellenlängenbereich sich über einen Bereich von 315 bis 450 nm, bevorzugt von 350 bis 420 nm, bevorzugter von 360 bis 410 nm, erstreckt.

In einer erfindungsgemäßen Ausführungsform 3 ist die Vorrichtung nach ihrer Ausführungsform 1 oder 2 ausgestaltet, wobei sich der weitere Wellenlängenbereich über einen Bereich von 280 bis weniger als 315 nm; oder über einen Bereich von 10 bis weniger als 280 nm, bevorzugt von 100 bis weniger als 280 nm, bevorzugter von 200 bis weniger als 280 nm; oder über beide Bereiche erstreckt. Bevorzugt beinhaltet der weitere Wellenlängenbereich einen Wellenlängenbereich von UV-B-Strahlung, oder von UV-C-Strahlung, oder von beiden. Besonders bevorzugt beinhaltet der weitere Wellenlängenbereich einen Wellenlängenbereich von UV-C-Strahlung, oder von UV-C-Strahlung und UV-B-Strahlung. Bevorzugter besteht der weitere Wellenlängenbereich aus einem Wellenlängenbereich von UV-B-Strahlung, oder von UV-C-Strahlung, oder aus beiden Wellenlängenbereichen, wobei hier der Wellenlängenbereich von UV-C-Strahlung, oder von UV-C-Strahlung und UV-B-Strahlung besonders bevorzugt ist.

In einer erfindungsgemäßen Ausführungsform 4 ist die Vorrichtung nach einer ihrer vorhergehenden Ausführungsformen ausgestaltet, wobei jedes lichtemittierende Halbleiterbauelement der ersten Art dazu angeordnet und ausgebildet ist, Licht mit einem Spektrum, beinhaltend ein lokales Intensitätsmaximum in dem ersten Wellenlängenbereich mit einer Halbwertsbreite in einem Bereich von 3 bis 50 nm, bevorzugt von 5 bis 40 nm, bevorzugter von 10 bis 30 nm, am bevorzugtesten von 15 bis 25 nm, abzustrahlen.

In einer erfindungsgemäßen Ausführungsform 5 ist die Vorrichtung nach einer ihrer vorhergehenden Ausführungsformen ausgestaltet, wobei jedes lichtemittierende Halbleiterbauelement der weiteren Art dazu angeordnet und ausgebildet ist, Licht mit einem Spektrum, beinhaltend ein lokales Intensitätsmaximum in dem weiteren Wellenlängenbereich mit einer Halbwertsbreite in einem Bereich von 3 bis 50 nm, bevorzugt von 5 bis 40 nm, bevorzugter von 10 bis 30 nm, am bevorzugtesten von 15 bis 25 nm, abzustrahlen.

In einer erfindungsgemäßen Ausführungsform 6 ist die Vorrichtung nach einer ihrer vorhergehenden Ausführungsformen ausgestaltet, wobei die erste Vielzahl von lichtemittierenden Halbleiterbauelementen mindestens ein erstes lichtemittierendes Halbleiterbauelement der weiteren Art und mindestens ein weiteres lichtemittierende Halbleiterbauelement der weiteren Art beinhaltet, wobei das mindestens eine erste lichtemittierende Halbleiterbauelement der weiteren Art dazu angeordnet und ausgebildet ist, Licht mit einem Spektrum, beinhaltend ein lokales Intensitätsmaximum in einem Wellenlängenbereich von 280 bis weniger als 315 nm, abzustrahlen, wobei das mindestens eine weitere lichtemittierende Halbleiterbauelement der weiteren Art dazu angeordnet und ausgebildet ist, Licht mit einem Spektrum, beinhaltend ein lokales Intensitätsmaximum in einem Wellenlängenbereich von 10 bis weniger als 280 nm, bevorzugt von 100 bis weniger als 280 nm, bevorzugter von 200 bis weniger als 280 nm, abzustrahlen.

In einer erfindungsgemäßen Ausführungsform 7 ist die Vorrichtung nach einer ihrer vorhergehenden Ausführungsformen ausgestaltet, wobei die erste Vielzahl von lichtemittierenden Halbleiterbauelementen mindestens eines, ausgewählt aus der Gruppe, bestehend aus einem lichtemittierenden Halbleiterbauelement der ersten Art, das dazu angeordnet und ausgebildet ist, Licht mit einem Spektrum, beinhaltend ein lokales Intensitätsmaximum bei einer Wellenlänge in einem Bereich von 360 bis 370 nm, bevorzugt von 363 bis 367 nm, abzustrahlen; einem lichtemittierenden Halbleiterbauelement der ersten Art, das dazu angeordnet und ausgebildet ist, Licht mit einem Spektrum, beinhaltend ein lokales Intensitätsmaximum bei einer Wellenlänge in einem Bereich von 380 bis 390 nm, bevorzugt von 383 bis 387 nm, abzustrahlen; einem lichtemittierenden Halbleiterbauelement der ersten Art, das dazu angeordnet und ausgebildet ist, Licht mit einem Spektrum, beinhaltend ein lokales Intensitätsmaximum bei einer Wellenlänge in einem Bereich von 390 bis 400 nm, bevorzugt von 393 bis 397 nm, abzustrahlen; und einem lichtemittierenden Halbleiterbauelement der ersten Art, das dazu angeordnet und ausgebildet ist, Licht mit einem Spektrum, beinhaltend ein lokales Intensitätsmaximum bei einer Wellenlänge in einem Bereich von 400 bis 410 nm, bevorzugt von 403 bis 407 nm, abzustrahlen; oder eine Kombination aus mindestens zwei davon beinhaltet.

In einer erfindungsgemäßen Ausführungsform 8 ist die Vorrichtung nach einer ihrer vorhergehenden Ausführungsformen ausgestaltet, wobei die lichtemittierenden Halbleiterbauelemente der ersten Art durch erste Betriebsspannungen gekennzeichnet sind, wobei die lichtemittierenden Halbleiterbauelemente der weiteren Art durch von den ersten Betriebsspannungen verschiedene weitere Betriebsspannungen gekennzeichnet sind. Hierbei können die ersten Betriebsspannungen gleich oder untereinander verschieden sein. Ferner können die weiteren Betriebsspannungen gleich oder untereinander verschieden sein. Jeder der weiteren Betriebsspannungen unterscheidet sich von jeder der ersten Betriebsspannungen bevorzugt um mindestens 1 V, bevorzugter mindestens 2 V, noch bevorzugter mindestens 3 V, am bevorzugtesten mindestens 3,5 V.

In einer erfindungsgemäßen Ausführungsform 9 ist die Vorrichtung nach ihrer Ausführungsform 8 ausgestaltet, wobei die ersten Betriebsspannungen in einem Bereich von 3 bis 4,5 V liegen.

In einer erfindungsgemäßen Ausführungsform 10 ist die Vorrichtung nach ihrer Ausführungsform 8 oder 9 ausgestaltet, wobei die weiteren Betriebsspannungen in einem Bereich von 6,5 bis 9 V liegen.

In einer erfindungsgemäßen Ausführungsform 11 ist die Vorrichtung nach einer ihrer vorhergehenden Ausführungsformen ausgestaltet, wobei kein lichtemittierendes Halbleiterbauelement eines Parallelschaltpfads der ersten Vielzahl von Parallelschaltpfaden mit einem lichtemittierenden Halbleiterbauelement eines von diesem verschiedenen Parallelschaltpfad der ersten Vielzahl von Parallelschaltpfaden in Reihe geschaltet ist. Hierbei sind zwei lichtemittierende Halbleiterbauelemente in Reihe geschaltet, wenn sie in der elektrischen Schaltung in einer Stromflussrichtung elektrisch leitend miteinander verbunden nacheinander angeordnet sind. Nicht als Reihenschaltung angesehen werden hierbei kurzgeschlossene Schaltpfade. Die vorstehende Maßnahme ermöglicht insbesondere eine geringe Störanfälligkeit der Vorrichtung und einer die Vorrichtung beinhaltenden Lichtquelle.

In einer erfindungsgemäßen Ausführungsform 12 ist die Vorrichtung nach einer ihrer vorhergehenden Ausführungsformen ausgestaltet, wobei die Parallelschaltpfade der ersten Vielzahl von Parallelschaltpfaden zusammen die erste Vielzahl von lichtemittierenden Halbleiterbauelementen beinhalten.

In einer erfindungsgemäßen Ausführungsform 13 ist die Vorrichtung nach einer ihrer vorhergehenden Ausführungsformen ausgestaltet, wobei jedes lichtemittierende Halbleiterbauelement der ersten Art durch eine Betriebsstromstärke in einem Bereich von 0,3 bis 3 A, bevorzugt von 0,4 bis 2 A, bevorzugter von 0,5 bis 1,5 A, gekennzeichnet ist.

In einer erfindungsgemäßen Ausführungsform 14 ist die Vorrichtung nach einer ihrer vorhergehenden Ausführungsformen ausgestaltet, wobei jedes lichtemittierende Halbleiterbauelement der weiteren Art durch eine Betriebsstromstärke in einem Bereich von 100 mA bis 1 A, bevorzugt von 200 bis 800 mA, bevorzugter von 250 bis 600 mA, gekennzeichnet ist.

In einer erfindungsgemäßen Ausführungsform 15 ist die Vorrichtung nach einer ihrer vorhergehenden Ausführungsformen ausgestaltet, wobei die Vielzahl von lichtemittierenden Halbleiterbauelementen der ersten Art mindestens 2, bevorzugt mindestens 3, bevorzugter mindestens 4, lichtemittierende Halbleiterbauelemente beinhaltet, die dazu angeordnet und ausgebildet sind, Licht mit Spektren, beinhaltend lokale Intensitätsmaxima bei jeweils voneinander verschiedenen Wellenlängen, abzustrahlen. Hierbei liegen die vorgenannten lokalen Intensitätsmaxima vorzugsweise bei Wellenlängen, die sich voneinander um mindestens 3 nm, bevorzugter mindestens 5 nm, noch bevorzugter mindestens 8 nm, am bevorzugtesten mindestens 9 nm, beispielsweise um etwa 10 nm, unterscheiden.

In einer erfindungsgemäßen Ausführungsform 16 ist die Vorrichtung nach ihrer Ausführungsform 15 ausgestaltet, wobei die mindestens 2 lichtemittierenden Halbleiterbauelemente der Vielzahl von lichtemittierenden Halbleiterbauelementen der ersten Art in voneinander verschiedenen Parallelschaltpfaden der ersten Vielzahl von Parallelschaltpfaden angeordnet sind.

In einer erfindungsgemäßen Ausführungsform 17 ist die Vorrichtung nach einer ihrer vorhergehenden Ausführungsformen ausgestaltet, wobei das Substrat einstückig ausgebildet ist. Ein Element ist einstückig ausgebildet, wenn es in einem Stück, vorzugsweise aus einem formlosen Stoff, gefertigt wurde, ohne nachträgliches Fügen verschiedener Bestandteile. Demnach beinhaltet das Substrat vorzugsweise keine Fügestelle, wie beispielsweise eine Naht, Schweißstelle, Lötstelle oder Klebestelle.

In einer erfindungsgemäßen Ausführungsform 18 ist die Vorrichtung nach einer ihrer vorhergehenden Ausführungsformen ausgestaltet, wobei das Substrat eine Keramik beinhaltet, bevorzugt daraus besteht.

In einer erfindungsgemäßen Ausführungsform 19 ist die Vorrichtung nach einer ihrer vorhergehenden Ausführungsformen ausgestaltet, wobei das Substrat eines ausgewählt aus der Gruppe, bestehend aus Aluminiumnitrid, Aluminiumoxid, bevorzugt AlO, und ein Metall, oder eine Kombination aus mindestens zwei davon beinhaltet, bevorzugt daraus besteht. Ein bevorzugtes Metall ist Aluminium oder Kupfer oder beides.

In einer erfindungsgemäßen Ausführungsform 20 ist die Vorrichtung nach einer ihrer vorhergehenden Ausführungsformen ausgestaltet, wobei das Substrat als einander überlagernde Schichten einer Schichtfolge in Richtung von einer der elektrischen Schaltung zugewandten Seite des Substrats zu einer gegenüberliegenden Seite des Substrats
a. eine Beschichtung, und
b. eine Trägerschicht
beinhaltet. Eine bevorzugte Trägerschicht beinhaltet eines ausgewählt aus der Gruppe, bestehend aus Aluminiumnitrid, Aluminiumoxid, bevorzugt AlO, und ein Metall, oder eine Kombination aus mindestens zwei davon. Bevorzugter besteht die Trägerschicht aus dem Vorgenannten. Ein bevorzugtes Metall ist Aluminium oder Kupfer oder beides. Eine bevorzugte Beschichtung beinhaltet ein Glas. Eine bevorzugte Beschichtung ist elektrisch isolierend. Bevorzugt ist die Beschichtung aus einer Paste, bevorzugter einer Dickfilmpaste wie Heraeus Celsion® von Heraeus Deutschland GmbH & Co. KG, erhältlich.

In einer erfindungsgemäßen Ausführungsform 21 ist die Vorrichtung nach einer ihrer vorhergehenden Ausführungsformen ausgestaltet, wobei die elektrische Schaltung eine erste doppel-T-förmige Leiterbahn beinhaltet, wobei die erste doppel-T-förmige Leiterbahn einen ersten Querbalken, einen weiteren Querbalken und einen den ersten Querbalken mit dem weiteren Querbalken elektrisch verbindenden Längsbalken beinhaltet. Eine bevorzugte erste doppel-T-förmige Leiterbahn ist eine gedruckte Leiterbahn. Diese Maßnahme erlaubt insbesondere eine vorteilhafte Balance aus besonders kompakter Bauweise und geringem Herstellungsaufwand und/oder geringer Verfahrensdauer eines Herstellungsverfahrens für die Vorrichtung und eine die Vorrichtung beinhaltende Lichtquelle. Bevorzugt sind der erste Querbalken, der Längsbalken und der weitere Querbalken in einer Stromflussrichtung, oder in der Vorwärtsrichtung der lichtemittierenden Halbleiterbauelemente der ersten Vielzahl von lichtemittierenden Halbleiterbauelementen oder entgegen dieser Vorwärtsrichtung nacheinander angeordnet. Besonders bevorzugt grenzen der erste Querbalken, der Längsbalken und der weitere Querbalken aneinander an.

In einer erfindungsgemäßen Ausführungsform 22 ist die Vorrichtung nach ihrer Ausführungsform 21 ausgestaltet, wobei der erste Querbalken der ersten doppel-T-förmigen Leiterbahn die ersten Enden der Parallelschaltpfade der ersten Vielzahl von Parallelschaltpfaden elektrisch leitend miteinander verbindet.

In einer erfindungsgemäßen Ausführungsform 23 ist die Vorrichtung nach ihrer Ausführungsform 21 oder 22 ausgestaltet, wobei die erste Vielzahl von Parallelschaltpfaden den Längsbalken oder den weiteren Querbalken der ersten doppel-T-förmigen Leiterbahn oder beide beinhaltet.

In einer erfindungsgemäßen Ausführungsform 24 ist die Vorrichtung nach einer ihrer Ausführungsformen 21 bis 23 ausgestaltet, wobei die lichtemittierenden Halbleiterbauelemente der weiteren Art der ersten Vielzahl von lichtemittierenden Halbleiterbauelementen mittels Bonddrähten mit dem Längsbalken oder dem weiteren Querbalken der ersten doppel-T-förmigen Leiterbahn oder mit beiden elektrisch leitend verbunden sind.

In einer erfindungsgemäßen Ausführungsform 25 ist die Vorrichtung nach einer ihrer Ausführungsformen 21 bis 24 ausgestaltet, wobei die elektrische Schaltung zusätzlich eine weitere doppel-T-förmige Leiterbahn beinhaltet, wobei die weitere doppel-T-förmige Leiterbahn einen ersten Querbalken, einen weiteren Querbalken und einen den ersten Querbalken mit dem weiteren Querbalken elektrisch verbindenden Längsbalken beinhaltet, wobei der erste Querbalken der weiteren doppel-T-förmigen Leiterbahn die weiteren Enden der Parallelschaltpfade der ersten Vielzahl von Parallelschaltpfaden elektrisch leitend miteinander verbindet. Bevorzugt sind der erste Querbalken, der Längsbalken und der weitere Querbalken der weiteren doppel-T-förmigen Leiterbahn in einer Stromflussrichtung, oder in der Vorwärtsrichtung der lichtemittierenden Halbleiterbauelemente der ersten Vielzahl von lichtemittierenden Halbleiterbauelementen oder entgegen dieser Vorwärtsrichtung nacheinander angeordnet. Besonders bevorzugt grenzen dieser erste Querbalken, dieser Längsbalken und dieser weitere Querbalken aneinander an.

In einer erfindungsgemäßen Ausführungsform 26 ist die Vorrichtung nach ihrer Ausführungsform 25 ausgestaltet, wobei der erste Querbalken der ersten doppel-T-förmige Leiterbahn entlang von Parallelschaltpfade der ersten Vielzahl von Parallelschaltpfaden, bevorzugt entlang aller Parallelschaltpfade der ersten Vielzahl von Parallelschaltpfaden, mittels Bonddrähten mit dem ersten Querbalken der weiteren doppel-T-förmigen Leiterbahn elektrisch leitend verbunden ist. "Mittels Bonddrähten" heißt hier, dass die genannten Parallelschaltpfade Bonddrähte beinhalten. Die beiden ersten Querbalken können also unmittelbar mittels der Bonddrähte verbunden sein oder, was bevorzugt ist, mittelbar, das heißt mit weiteren elektrisch leitenden Elementen zwischen den beiden ersten Querbalken.

In einer erfindungsgemäßen Ausführungsform 27 ist die Vorrichtung nach ihrer Ausführungsform 25 oder 26 ausgestaltet, wobei der weitere Querbalken der ersten doppel-T-förmigen Leiterbahn entlang mindestens eines Teils der Parallelschaltpfade der ersten Vielzahl von Parallelschaltpfaden mittels Bonddrähten mit dem ersten Querbalken der weiteren doppel-T-förmigen Leiterbahn elektrisch leitend verbunden ist.

In einer erfindungsgemäßen Ausführungsform 28 ist die Vorrichtung nach einer ihrer vorhergehenden Ausführungsformen ausgestaltet, wobei die elektrische Schaltung mindestens einen, bevorzugt in der Vorwärtsrichtung oder dieser entgegensetzt nach dem ersten Abschnitt angeordneten, weiteren Abschnitt beinhaltet, wobei der weitere Abschnitt
a} eine weitere Vielzahl von lichtemittierenden Halbleiterbauelementen, beinhaltend
   i} eine Vielzahl von lichtemittierenden Halbleiterbauelementen der ersten Art, und
   ii} mindestens ein lichtemittierendes Halbleiterbauelement der weiteren Art, und
b} eine weitere Vielzahl von parallel zueinander geschalteten Parallelschaltpfaden beinhaltet, wobei jeder der Parallelschaltpfade der weiteren Vielzahl von Parallelschaltpfaden
   a: ein erstes Ende, und
   b: ein, in einer Vorwärtsrichtung der lichtemittierenden Halbleiterbauelemente der weiteren Vielzahl von lichtemittierenden Halbleiterbauelementen oder entgegen dieser Vorwärtsrichtung, gegenüberliegendes weiteres Ende
beinhaltet, wobei die ersten Enden der Parallelschaltpfade der weiteren Vielzahl von Parallelschaltpfaden miteinander elektrisch leitend verbunden sind, wobei die weiteren Enden der Parallelschaltpfade der weiteren Vielzahl von Parallelschaltpfaden elektrisch leitend miteinander verbunden sind, wobei mindestens einer der Parallelschaltpfade der weiteren Vielzahl von Parallelschaltpfaden ein lichtemittierendes Halbleiterbauelement der ersten Art beinhaltet, wobei jeder Parallelschaltpfad der weiteren Vielzahl von Parallelschaltpfaden gekennzeichnet ist durch eine Betriebsspannungssumme, die eine Summe der Betriebsspannungen der lichtemittierenden Halbleiterbauelemente in dem jeweiligen Parallelschaltpfad ist, wobei keine Betriebsspannungssumme der Parallelschaltpfade der weiteren Vielzahl von Parallelschaltpfaden um mehr als 0,6 V, bevorzugt um mehr als 0,5 V, bevorzugt mehr als 0,4 V, bevorzugter mehr als 0,3 V, noch bevorzugter mehr als 0,2V, am bevorzugtesten mehr als 0,1 V, von einer Betriebsspannungssumme der Parallelschaltpfade der weiteren Vielzahl von Parallelschaltpfaden abweicht. Die weitere Vielzahl von Parallelschaltpfaden beinhaltet mindestens 2, bevorzugt mindestens 3, bevorzugter mindestens 4, Parallelschaltpfade. Die Vielzahl von lichtemittierenden Halbleiterbauelementen der ersten Art in der weiteren Vielzahl von lichtemittierenden Halbleiterbauelementen beinhaltet mindestens 2, bevorzugt mindestens 4, bevorzugter mindestens 5, noch bevorzugter mindestens 8, lichtemittierenden Halbleiterbauelementen der ersten Art. Alternativ oder zusätzlich bevorzugt beinhaltet die Vielzahl von lichtemittierenden Halbleiterbauelementen der ersten Art in der weiteren Vielzahl von lichtemittierenden Halbleiterbauelementen mindestens doppelt so viele lichtemittierende Halbleiterbauelemente der ersten Art wie die weitere Vielzahl von lichtemittierenden Halbleiterbauelementen solche der weiteren Art beinhaltet.

In einer erfindungsgemäßen Ausführungsform 29 ist die Vorrichtung nach einer ihrer vorhergehenden Ausführungsformen ausgestaltet, wobei die lichtemittierenden Halbleiterbauelemente der ersten Art Leuchtdioden der ersten Art sind.

In einer erfindungsgemäßen Ausführungsform 30 ist die Vorrichtung nach ihrer Ausführungsform 29 ausgestaltet, wobei die Leuchtdioden der ersten Art UV-Leuchtdioden, bevorzugt UV-A-Leuchtdioden, sind.

In einer erfindungsgemäßen Ausführungsform 31 ist die Vorrichtung nach einer ihrer vorhergehenden Ausführungsformen ausgestaltet, wobei die lichtemittierenden Halbleiterbauelemente der weiteren Art Leuchtdioden der weiteren Art sind.

In einer erfindungsgemäßen Ausführungsform 32 ist die Vorrichtung nach ihrer Ausführungsform 31 ausgestaltet, wobei die Leuchtdioden der weiteren Art UV-Leuchtdioden, bevorzugt UV-B-Leuchtdioden oder UV-C-Leuchtdioden oder eine Mischung dieser beiden, sind, wobei hier UV-C-Leuchtdioden besonders bevorzugt sind.

In einer erfindungsgemäßen Ausführungsform 33 ist die Vorrichtung nach einer ihrer vorhergehenden Ausführungsformen ausgestaltet, wobei die lichtemittierenden Halbleiterbauelemente der ersten Vielzahl von lichtemittierenden Halbleiterbauelementen Leuchtdioden, bevorzugt UV-Leuchtdioden, sind.

In einer erfindungsgemäßen Ausführungsform 34 ist die Vorrichtung nach einer ihrer vorhergehenden Ausführungsformen ausgestaltet, wobei die Vorrichtung ein LED-Modul beinhaltet, bevorzugt ist.

Einen Beitrag zur Erfüllung mindestens einer der erfindungsgemäßen Aufgaben leistet eine Ausführungsform 1 einer Lichtquelle, beinhaltend die erfindungsgemäße Vorrichtung nach einer ihrer Ausführungsformen.

In einer erfindungsgemäßen Ausführungsform 2 ist die Lichtquelle nach ihrer Ausführungsform 1 ausgestaltet, wobei die Lichtquelle zu einem, ausgewählt aus der Gruppe, bestehend aus einer Verwendung in einer Druckmaschine; zu einem Härten einer Schutzschicht; und zu einem Härten einer flächenförmigen Schicht eines mehrschichtigen Verbunds; oder zu einer Kombination aus mindestens zwei davon ausgebildet, bevorzugt zusätzlich angeordnet, ist. Allgemein ist für die vorstehende Schutzschicht sowie für die flächenförmige Schicht eine Polymerschicht bevorzugt. Eine Polymerschicht ist eine Schicht, die nach dem Härten ein oder mehrere Polymere insgesamt zu mindestens 50 Gew.-%, bevorzugt zu mindestens 60 Gew.-%, bevorzugter zu mindestens 70 Gew.-%, bevorzugter zu mindestens 80 Gew.-%, am bevorzugtesten zu mindestens 90 Gew.-%, bezogen auf das Gesamtgewicht der Polymerschicht, beinhaltet. Bevorzugt besteht die Polymerschicht aus einem oder mehreren Polymeren. Eine bevorzugte Schutzschicht ist ein Schutzlack. Ein bevorzugtes Härten einer Schutzschicht ist hierbei eines, ausgewählt aus der Gruppe, bestehend aus einem Härten einer Beschichtung eines holzfaserhaltigen Bauteils; einem Härten einer Beschichtung eines Bodenbelags; und einem Härten eines Mantels oder einer Schutzhülle oder beider eines Lichtwellenleiters (auch Glasfaserkabel genannt); oder eine Kombination aus mindestens zwei davon. Ein bevorzugter mehrschichtiger Verbund ist eine Folie. Ein bevorzugtes Härten einer flächenförmigen Schicht eines mehrschichtigen Verbunds ist eines, ausgewählt aus der Gruppe, bestehend aus einem Härten einer Schicht einer Anzeige; einem Härten einer Schicht in einem Foliendruckverfahren; und einem Härten einer Schicht in einem Folienlaminierungsverfahren; oder eine Kombination aus mindestens zwei davon Ein bevorzugtes holzfaserhaltiges Bauteil ist ein Möbelstück. Alternativ oder zusätzlich bevorzugt besteht ein bevorzugtes holzfaserhaltiges Bauteil zumindest teilweise aus Holz. Ein bevorzugter Bodenbelag ist ein Parkett oder ein Laminatfußbodenbelag oder beides. Eine bevorzugte Anzeige eine elektrisch angesteuerte Anzeige. Eine bevorzugte elektrisch angesteuerte Anzeige ist ein Display, bevorzugt ein Display eines Handheld-Devices (auch Handheld oder Handgerät), oder ein Monitor, oder beides.

In einer erfindungsgemäßen Ausführungsform 3 ist die Lichtquelle nach ihrer Ausführungsform 1 oder 2 ausgestaltet, wobei die Lichtquelle ein Vorschaltgerät beinhaltet. Ein bevorzugtes Vorschaltgerät ist eine elektronisches Vorschaltgerät. Ein bevorzugtes elektronisches Vorschaltgerät ist ein LED-Treiber.

Einen Beitrag zur Erfüllung mindestens einer der erfindungsgemäßen Aufgaben leistet eine Ausführungsform 1 einer Druckmaschine, beinhaltend die erfindungsgemäße Lichtquelle nach einer ihrer Ausführungsformen. Als erfindungsgemäße Druckmaschine kommt jede Art Druckmaschine in Betracht, die sich zum Einsatz der erfindungsgemäßen Lichtquelle eignet. Eine bevorzugte Druckmaschine ist zu einem Durchführen des erfindungsgemäßen Verfahrens 1 nach einer seiner Ausführungsformen ausgebildet.

In einer erfindungsgemäßen Ausführungsform 2 ist die Druckmaschine nach ihrer Ausführungsform 1 ausgestaltet, wobei die Lichtquelle in der Druckmaschine zu einem Bestrahlen einer auf einen Druckträger gedruckten Zusammensetzung angeordnet und ausgebildet ist.

In einer erfindungsgemäßen Ausführungsform 3 ist die Druckmaschine nach ihrer Ausführungsform 2 ausgestaltet, wobei die Zusammensetzung eine Druckfarbe oder ein Lack oder beides ist.

In einer erfindungsgemäßen Ausführungsform 4 ist die Druckmaschine nach einer ihrer vorhergehenden Ausführungsformen ausgestaltet, wobei die Druckmaschine eine Spannungsquelle beinhaltet, wobei die Lichtquelle elektrisch mit der Spannungsquelle kontaktiert ist.

In einer erfindungsgemäßen Ausführungsform 5 ist die Druckmaschine nach ihrer Ausführungsform 4 ausgestaltet, wobei die Spannungsquelle durch eine Leerlaufspannung in einem Bereich von 10 bis 250 V, bevorzugt von 10 bis 100 V, bevorzugter von 30 bis 80 V, noch bevorzugter von 40 bis 60 V, am bevorzugtesten von etwa 48 V, gekennzeichnet ist.

In einer erfindungsgemäßen Ausführungsform 6 ist die Druckmaschine nach ihrer Ausführungsform 4 oder 5ausgestaltet, wobei die Spannungsquelle durch eine Kurzschlussstromstärke in einem Bereich von 1 bis 20 A, bevorzugt von 2 bis 10 A, bevorzugter von 3 bis 7 A, noch bevorzugter von 4 bis 6 A, am bevorzugtesten von etwa 5 A, gekennzeichnet ist.

In einer erfindungsgemäßen Ausführungsform 7 ist die Druckmaschine nach einer ihrer vorhergehenden Ausführungsformen ausgestaltet, wobei die Druckmaschine eine druckbildspeicherlose Druckmaschine ist. Eine bevorzugte druckbildspeicherlose Druckmaschine ist für ein berührungsloses Drucken (Non Impact Printing - NIP) ausgebildet. Eine bevorzugte druckbildspeicherlose Druckmaschine ist ein Tintenstrahldrucker oder ein Laserdrucker oder beides.

In einer erfindungsgemäßen Ausführungsform 8 ist die Druckmaschine nach einer ihrer Ausführungsformen 1 bis 6 ausgestaltet, wobei die Druckmaschine einen Druckbildspeicher beinhaltet. Ein bevorzugter Druckbildspeicher ist eine Druckwalze oder eine Druckplatte. Eine bevorzugt Druckmaschine, die einen Druckbildspeicher beinhaltet, ist eine Flexodruckmaschine.

In einer erfindungsgemäßen Ausführungsform 9 ist die Druckmaschine nach ihrer Ausführungsform 8 ausgestaltet, wobei die Druckmaschine für ein indirektes Drucken mittels des Druckbildspeichers angeordnet und ausgebildet ist. Eine bevorzugte Druckmaschine für ein indirektes Drucken ist eine Offset-Druckmaschine. Eine bevorzugte Offset-Druckmaschine ist eine Bogen-Offset-Druckmaschine.

Einen Beitrag zur Erfüllung mindestens einer der erfindungsgemäßen Aufgaben leistet eine Ausführungsform 1 eines Verfahrens 1, beinhaltend als Verfahrensschritte
A) Bereitstellen
   I) der erfindungsgemäßen Lichtquelle nach einer ihrer Ausführungsformen, und
   II) eines Objekts;
B) Überlagern des Objekts mit einer Zusammensetzung; und
C) Bestrahlen der Zusammensetzung mit von mindestens einem Teil der lichtemittierenden Halbleiterbauelemente der ersten Vielzahl von lichtemittierenden Halbleiterbauelementen abgestrahltem Licht.

In einer erfindungsgemäßen Ausführungsform 2 ist das Verfahren 1 nach seiner Ausführungsform 1 ausgestaltet, wobei die Zusammensetzung in dem Verfahrensschritt B), bevorzugt auch in dem Verfahrensschritt C), flüssig ist.

In einer erfindungsgemäßen Ausführungsform 3 ist das Verfahren 1 nach seiner Ausführungsform 1 oder 2 ausgestaltet, wobei die Zusammensetzung in dem Verfahrensschritt B) mindestens ein Farbmittel, bevorzugt zu einem Anteil in einem Bereich von 0,5 bis 20 Gew.-%, bevorzugter von 1 bis 15 Gew.-%, bevorzugter von 2 bis 10 Gew.-%, am bevorzugtesten von 3 bis 8 Gew.-%, jeweils bezogen auf die Zusammensetzung in dem Verfahrensschritt B), beinhaltet.

In einer erfindungsgemäßen Ausführungsform 4 ist das Verfahren 1 nach einer seiner vorhergehenden Ausführungsformen ausgestaltet, wobei die Zusammensetzung in dem Verfahrensschritt B) ein Vehikel, bevorzugt zu einem Anteil in einem Bereich von 10 bis 95 Gew.-%, bevorzugter von 20 bis 95 Gew.-%, bevorzugter von 30 bis 95 Gew.-%, am bevorzugtesten von 40 bis 90 Gew.-%, jeweils bezogen auf die Zusammensetzung in dem Verfahrensschritt B), beinhaltet.

In einer erfindungsgemäßen Ausführungsform 5 ist das Verfahren 1 nach einer seiner vorhergehenden Ausführungsformen ausgestaltet, wobei die Zusammensetzung in dem Verfahrensschritt B) einen Photoinitiator, bevorzugt zu einem Anteil in einem Bereich von 1 bis 30 Gew.-%, bevorzugter von 2 bis 25 Gew.-%, bevorzugter von 3 bis 20 Gew.-%, am bevorzugtesten von 5 bis 15 Gew.-%, jeweils bezogen auf die Zusammensetzung in dem Verfahrensschritt B), beinhaltet.

In einer erfindungsgemäßen Ausführungsform 6 ist das Verfahren 1 nach einer seiner vorhergehenden Ausführungsformen ausgestaltet, wobei die Zusammensetzung in dem Verfahrensschritt B) mindestens ein Monomer, bevorzugt zu einem Anteil in einem Bereich von 10 bis 95 Gew.-%, bevorzugter von 20 bis 95 Gew.-%, bevorzugter von 30 bis 90 Gew.-%, bevorzugter von 40 bis 85 Gew.-%, bevorzugter von 50 bis 85 Gew.-%, am bevorzugtesten von 60 bis 80 Gew.-%, jeweils bezogen auf die Zusammensetzung in dem Verfahrensschritt B), beinhaltet.

In einer erfindungsgemäßen Ausführungsform 7 ist das Verfahren 1 nach einer seiner vorhergehenden Ausführungsformen ausgestaltet, wobei die Zusammensetzung in dem Verfahrensschritt B) mindestens ein Oligomer, bevorzugt zu einem Anteil in einem Bereich von 1 bis 50 Gew.-%, bevorzugt von 1 bis 40 Gew.-%, bevorzugter von 2 bis 30 Gew.-%, bevorzugter von 3 bis 25 Gew.-%, am bevorzugtesten von 5 bis 20 Gew.-%, jeweils bezogen auf die Zusammensetzung in dem Verfahrensschritt B), beinhaltet.

In einer erfindungsgemäßen Ausführungsform 8 ist das Verfahren 1 nach einer seiner vorhergehenden Ausführungsformen ausgestaltet, wobei der Verfahrensschritt C) ein Härten der Zusammensetzung beinhaltet.

In einer erfindungsgemäßen Ausführungsform 9 ist das Verfahren 1 nach seiner Ausführungsform 8 ausgestaltet, wobei das Härten ein Verringern eines Anteils eines Vehikels in der Zusammensetzung, bevorzugt um mindestens 50 Gew.-%, bevorzugter um mindestens 60 Gew.-%, bevorzugter um mindestens 70 Gew.-%, noch bevorzugter um mindestens 80 Gew.-%, am bevorzugtesten um mindestens 90 Gew.-%, jeweils bezogen auf den Anteil des Vehikels in der Zusammensetzung vor dem Härten, beinhaltet.

In einer erfindungsgemäßen Ausführungsform 10 ist das Verfahren 1 nach seiner Ausführungsform 8 oder 9 ausgestaltet, wobei das Härten ein Polymerisieren eines Monomers oder eines Oligomers oder beider in der Zusammensetzung beinhaltet.

In einer erfindungsgemäßen Ausführungsform 11 ist das Verfahren 1 nach einer seiner vorhergehenden Ausführungsformen ausgestaltet, wobei die Zusammensetzung eine Druckfarbe oder ein Lack oder beides ist.

In einer erfindungsgemäßen Ausführungsform 12 ist das Verfahren 1 nach einer seiner vorhergehenden Ausführungsformen ausgestaltet, wobei in dem Verfahrensschritt C) das Bestrahlen der Zusammensetzung mit dem von mindestens einem Teil der lichtemittierenden Halbleiterbauelemente der ersten Vielzahl von lichtemittierenden Halbleiterbauelementen abgestrahlten Licht ein zumindest teilweise gleichzeitiges Bestrahlen der Zusammensetzung mit von mindestens einem Teil der lichtemittierenden Halbleiterbauelemente der ersten Art und von mindestens einem Teil der lichtemittierenden Halbleiterbauelemente der weiteren Art abgestrahltem Licht beinhaltet.

In einer erfindungsgemäßen Ausführungsform 13 ist das Verfahren 1 nach einer seiner vorhergehenden Ausführungsformen ausgestaltet, wobei das Verfahren ein Verfahren zum Herstellen eines Druckerzeugnisses ist.

In einer erfindungsgemäßen Ausführungsform 14 ist das Verfahren 1 nach einer seiner vorhergehenden Ausführungsformen ausgestaltet, wobei in dem Verfahrensschritt A) die erfindungsgemäße Druckmaschine nach einer ihrer Ausführungsformen bereitgestellt wird.

In einer erfindungsgemäßen Ausführungsform 15 ist das Verfahren 1 nach einer seiner vorhergehenden Ausführungsformen ausgestaltet, wobei das Überlagern in dem Verfahrensschritt B) ein Bedrucken des Objekts mit der Zusammensetzung ist. Ein bevorzugtes Objekt ist hierbei ein Druckträger, auch Bedruckstoff genannt. Weitere bevorzugte Objekte sind die zur erfindungsgemäßen Anordnung hierin gelehrten Objekte.

Einen Beitrag zur Erfüllung mindestens einer der erfindungsgemäßen Aufgaben leistet eine Ausführungsform 1 eines Druckerzeugnisses, erhältlich durch das Verfahren 1 nach einer seiner Ausführungsformen.

In einer erfindungsgemäßen Ausführungsform 2 ist das Druckerzeugnis nach seiner Ausführungsform 1 ausgestaltet, wobei das Druckerzeugnis eines ausgewählt aus der Gruppe, bestehend aus einer Zeitschrift, einem Buch, einem Plakat, einem Werbemittel, und einem Etikett oder eine Kombination aus mindestens zwei davon ist.

Einen Beitrag zur Erfüllung mindestens einer der erfindungsgemäßen Aufgaben leistet eine Ausführungsform 1 einer Anordnung, beinhaltend
a] die erfindungsgemäße Lichtquelle nach einer ihrer Ausführungsformen, und
b] ein Bestrahlungsgut,
wobei die Lichtquelle und das Bestrahlungsgut zu einem Bestrahlen des Bestrahlungsguts mit von mindestens einem Teil der lichtemittierenden Halbleiterbauelementen der ersten Vielzahl von lichtemittierenden Halbleiterbauelementen abgestrahltem Licht angeordnet und ausgebildet sind. Bevorzugt sind die Lichtquelle und das Bestrahlungsgut zu einem zumindest teilweise gleichzeitigen Bestrahlen des Bestrahlungsguts mit von mindestens einem Teil der lichtemittierenden Halbleiterbauelemente der ersten Art und von mindestens einem Teil der lichtemittierenden Halbleiterbauelemente der weiteren Art abgestrahltem Licht angeordnet und ausgebildet.

In einer erfindungsgemäßen Ausführungsform 2 ist die Anordnung nach ihrer Ausführungsform 1 ausgestaltet, wobei das Bestrahlungsgut ein Objekt und eine das Objekt überlagernde Zusammensetzung beinhaltet, wobei die Lichtquelle und das Bestrahlungsgut zu einem Bestrahlen der Zusammensetzung mit dem von mindestens einem Teil der lichtemittierenden Halbleiterbauelementen der ersten Vielzahl von lichtemittierenden Halbleiterbauelementen abgestrahltem Licht angeordnet und ausgebildet sind. Ein bevorzugtes Objekt ist eines, ausgewählt aus der Gruppe, bestehend aus einem bahnförmigen Träger; einem flächenförmigen mehrschichtigen Verbund; einem holzfaserhaltigen Träger; einem Bodenbelags; einem Lichtwellenleiter; einem Vorläufer eines Lichtwellenleiters, beinhaltend dessen Kern; einer Anzeige; einem Vorläufer einer Anzeige; oder eine Kombination aus mindestens zwei davon. Ein bevorzugter holzfaserhaltiger Träger beinhaltet, bevorzugt besteht aus, einem Holzwerkstoff oder Papier. Ein bevorzugter Holzwerkstoff ist einer, ausgewählt aus der Gruppe, bestehend aus einem Vollholzwerkstoff, einem Furnierwerkstoff, einem Holzspanwerkstoff, einem Holzfaserwerkstoff, und einem Verbundstoff, oder eine Kombination aus mindestens zwei davon. Ein weiterer bevorzugter holzfaserhaltiger Träger ist ein Möbelstück oder eine Papierbahn. Ein bevorzugter Bodenbelag ist ein Parkett oder ein Laminatfußbodenbelag oder beides. Eine bevorzugte Anzeige eine elektrisch angesteuerte Anzeige. Eine bevorzugte elektrisch angesteuerte Anzeige ist ein Display, bevorzugt ein Display eines Handheld-Devices (auch Handheld oder Handgerät), oder ein Monitor, oder beides. Ein bevorzugter bahnförmiger Träger ist ein Druckträger. Alternativ oder zusätzlich beinhaltet der bevorzugte bahnförmige Träger eine Papierschicht oder besteht aus Papier. Ein bevorzugter bahnförmiger Träger, der Papier beinhaltet, ist eine Papierbahn. Ein weiterer bevorzugter bahnförmiger Träger ist eine Folie. Ferner ist ein bevorzugter flächenförmiger mehrschichtiger Verbund eine Folie. Die Zusammensetzung ist bevorzugt gemäß einer Ausführungsform des erfindungsgemäßen Verfahrens 1 ausgestaltet.

Einen Beitrag zur Erfüllung mindestens einer der erfindungsgemäßen Aufgaben leistet eine Ausführungsform 1 eines Verfahrens 2, beinhaltend als Verfahrensschritte
A] Bereitstellen der erfindungsgemäßen Anordnung nach einer ihrer Ausführungsformen; und
B] Bestrahlen des Bestrahlungsguts mit von mindestens einem Teil der lichtemittierenden Halbleiterbauelemente der ersten Vielzahl von lichtemittierenden Halbleiterbauelementen abgestrahltem Licht.

In einer erfindungsgemäßen Ausführungsform 2 ist das Verfahren 2 nach seiner Ausführungsform 1 ausgestaltet, wobei das Verfahren ein Verfahren zu dem Bestrahlen des Bestrahlungsguts.

In einer erfindungsgemäßen Ausführungsform 3 ist das Verfahren 2 nach seiner Ausführungsform 1 oder 2 ausgestaltet, wobei der Verfahrensschritt B] ein Härten einer Zusammensetzung beinhaltet. Das Verfahren 2 ist bevorzugt ein Verfahren zu einem Härten der Zusammensetzung.

In einer erfindungsgemäßen Ausführungsform 4 ist das Verfahren 2 nach seiner Ausführungsform 3 ausgestaltet, wobei das Härten ein Verringern eines Anteils eines Vehikels in der Zusammensetzung beinhaltet.

In einer erfindungsgemäßen Ausführungsform 5 ist das Verfahren 2 nach seiner Ausführungsform 3 oder 4 ausgestaltet, wobei das Härten ein Polymerisieren eines Monomers oder eines Oligomers oder beider in der Zusammensetzung beinhaltet.

In einer erfindungsgemäßen Ausführungsform 6 ist das Verfahren 2 nach einer seiner vorhergehenden Ausführungsformen ausgestaltet, wobei in dem Verfahrensschritt B] das Bestrahlen des Bestrahlungsguts mit dem von mindestens einem Teil der lichtemittierenden Halbleiterbauelemente der ersten Vielzahl von lichtemittierenden Halbleiterbauelementen abgestrahlten Licht ein zumindest teilweise gleichzeitiges Bestrahlen der Zusammensetzung mit von mindestens einem Teil der lichtemittierenden Halbleiterbauelemente der ersten Art und von mindestens einem Teil der lichtemittierenden Halbleiterbauelemente der weiteren Art abgestrahltem Licht beinhaltet.

Einen Beitrag zur Erfüllung mindestens einer der erfindungsgemäßen Aufgaben leistet eine Ausführungsform 1 einer Verwendung 1 der erfindungsgemäßen Lichtquelle nach einer ihrer Ausführungsformen in einer Druckmaschine. Eine bevorzugte Druckmaschine ist wie die erfindungsgemäße Druckmaschine nach einer ihrer Ausführungsformen ausgestaltet. Ferner wird die Lichtquelle in der Druckmaschine vorzugsweise zu einem Härten einer Zusammensetzung verwendet. Die Zusammensetzung ist bevorzugt gemäß einer Ausführungsform des erfindungsgemäßen Verfahrens 1 ausgestaltet. Das Härten erfolgt bevorzugt gemäß einer Ausführungsform des erfindungsgemäßen Verfahrens 1.

In einer erfindungsgemäßen Ausführungsform 2 ist die Verwendung 1 nach ihrer Ausführungsform 1 ausgestaltet, wobei die Verwendung ein zumindest teilweise gleichzeitig erfolgendes Bestrahlen mit von mindestens einem Teil der lichtemittierenden Halbleiterbauelemente der ersten Art und von mindestens einem Teil der lichtemittierenden Halbleiterbauelemente der weiteren Artabgestrahltem Licht beinhaltet.

Einen Beitrag zur Erfüllung mindestens einer der erfindungsgemäßen Aufgaben leistet eine Ausführungsform 1 einer Verwendung 2 der erfindungsgemäßen Lichtquelle nach einer ihrer Ausführungsformen zu einem Härten einer Zusammensetzung. Die Zusammensetzung ist bevorzugt gemäß einer Ausführungsform des erfindungsgemäßen Verfahrens 1 ausgestaltet. Ferner erfolgt das Härten bevorzugt gemäß einer Ausführungsform des erfindungsgemäßen Verfahrens 1.

Merkmale, die in einer erfindungsgemäßen Kategorie als bevorzugt beschrieben sind, beispielsweise nach der erfindungsgemäßen Vorrichtung oder Lichtquelle oder dem Verfahren 1 der Erfindung, sind ebenso in einer Ausführungsform der weiteren erfindungsgemäßen Kategorien, beispielsweise einer Ausführungsform der erfindungsgemäßen Anordnung oder der Verwendung 1 oder 2, bevorzugt.

### Lichtemittierendes Halbleiterbauelement

Als lichtemittierendes Halbleiterbauelement kommt im Rahmen der Erfindung jedes einen Halbleiter beinhaltende Bauteil in Frage, welches dem Fachmann als lichtemittierendes Bauelement der erfindungsgemäßen Vorrichtung oder der erfindungsgemäßen Lichtquelle geeignet erscheint. Ein lichtemittierendes Bauelement ist hierbei ein Bauteil, welcher zu einem Abstrahlen elektromagnetsicher Strahlung ausgebildet ist.

Der Begriff der elektromagnetischen Strahlung umfasst neben sichtbarem Licht auch für das menschliche Auge nicht sichtbare Bestandteile des elektromagnetischen Spektrums. Bevorzugte elektromagnetische Strahlung liegt im Wellenlängenbereich von 10 nm bis 1 mm. Ferner bevorzugte elektromagnetische Strahlung ist Infrarotstrahlung (IR-Strahlung) oder ultraviolette Strahlung (UV-Strahlung) oder eine Mischung aus beiden, wobei hier UV-Strahlung besonders bevorzugt ist. Gemäß der Norm DIN 5031-7 erstreckt sich der Wellenlängenbereich der UV-Strahlung von 10 bis 380 nm. Hierbei liegt UV-A-Strahlung definitionsgemäß im Bereich von 315 bis 380 nm, UV-B-Strahlung im Bereich von 280 bis 315 nm, UV-C-Strahlung im Bereich von 100 bis 280 nm, und EUV-Strahlung im Bereich von 10 bis 121 nm. Im Rahmen der Erfindung ist UV-Strahlung, ausgewählt aus der Gruppe, bestehend aus UV-A-Strahlung, UV-B-Strahlung, und UV-C-Strahlung, oder eine Kombination aus mindestens zwei davon besonderes bevorzugt. Hierbei ist zu berücksichtigen, dass die vorgenannte Norm zwar die Wellenlängenbereiche von UV-Strahlung definiert, im technischen Gebiet der Leuchtdioden (LED), welche wie untenstehend beschrieben im Rahmen der Erfindung bevorzugte lichtemittierende Halbleiterbauelemente sind, jedoch auch LED mit Maxima der abgestrahlten Intensität (im technischen Gebiet auch *Peakwellenlänge* genannt) bei Wellenlängen, die nicht in den in der Norm angegebenen Wellenlängenbereichen liegen, als UV-LED bezeichnet werden. Beispielsweise werden auch LED mit Maxima der abgestrahlten Intensität bei Wellenlängen von 385 nm, 395 nm und 405 nm als UV-A-LED bezeichnet. Im Rahmen der Erfindung gehören auch solche LED zu den bevorzugten lichtemittierenden Halbleiterbauelementen. Ferner wird hier die Bezeichnungsweise des technischen Gebiets übernommen und auch solche LED als UV-LED bezeichnet.

Bevorzugt beinhalten die lichtemittierenden Halbleiterbauelemente der erfindungsgemäßen Vorrichtung jeweils einen Halbleiterchip. Zumindest die Halbleiterchips der im Anspruch 1 genannten lichtemittierenden Halbleiterbauelemente der erfindungsgemäßen Vorrichtung sind gemeinsam auf dem Substrat der Vorrichtung angeordnet. Ein bevorzugtes lichtemittierendes Halbleiterbauelement beinhaltet zusätzlich mindestens eine den mindesten einen Halbleiterchip auf einer von dem Substrat abgewandten Seite überlagernde Optik. Hierbei kann eines oder mehrere, bevorzugt jedes, der lichtemittierenden Halbleiterbauelemente einzeln mit jeweils einer Optik ausgestattet sein. Ferner kann eine Optik auch mehreren lichtemittierenden Halbleiterbauelementen zugeordnet sein. Eine Optik ist hierin ein Element, welches zur Manipulation elektromagnetischer Strahlung angeordnet und ausgebildet ist. In Frage kommen hierbei sowohl optische Bauelemente als auch optische Komponenten. Eine bevorzugte Optik ist eine, ausgewählt aus der Gruppe, bestehend aus einer Transmissionsoptik, einer Konversionsoptik, und einer Reflexionsoptik, oder eine Kombination aus mindestens zwei davon. Eine Transmissionsoptik ist eine Optik, die zur Manipulation der elektromagnetischen Strahlung von dieser durchquert wird. Eine bevorzugte Transmissionsoptik ist eine Linse oder ein Transmissionsgitter. Eine Konversionsoptik ist eine Optik, die zur Veränderung einer Wellenlänge elektromagnetischer Strahlung angeordnet und ausgebildet ist. Diese kann im Fall einer LED vorzugsweise zum Anpassen einer Farbe des von der LED emittierten Lichts dienen. Eine bevorzugte Konversionsoptik ist eine Konversionsschicht, also eine mindestens einen Fluoreszenzfarbstoff beinhaltende Schicht. Eine Reflexionsoptik ist eine Optik, die zur Manipulation der elektromagnetischen Strahlung, insbesondere einer Ausbreitungsrichtung der elektromagnetischen Strahlung, diese reflektiert. Eine bevorzugte Reflexionsoptik ist ein Spiegel oder ein Reflexionsgitter.

Zu den lichtemittierenden Halbleiterbauelementen gehören insbesondere Leuchtdioden (LED) und Laserdioden (auch Halbleiterlaser genannt), wobei Leuchtdioden hier besonders bevorzugt sind. Eine besonders bevorzugte LED ist eine IR-LED oder eine UV-LED oder beides, wobei hier ganz besonders UV-LED bevorzugt sind. Eine bevorzugte UV-LED ist eine, ausgewählt aus der Gruppe, bestehend aus eine UV-A-LED, einer UV-B-LED, und einer UV-C-LED, oder eine Kombination aus mindestens zwei davon.

### Vorrichtung

Als erfindungsgemäße Vorrichtung kommt jede Vorrichtung in Frage, die die Merkmale des Anspruchs 1 aufweist. Im Fall einer LED als lichtemittierendes Halbleiterbauelement wird der oben beschriebene Aufbau, beinhaltend das Substrat und die Halbleiterchips und, optional, eine oder mehrere Optiken, im technischen Gebiet auch als *Package* bezeichnet. Bevorzugt ist zumindest eine Oberfläche des Substrats, auf der die elektrische Schaltung angeordnet ist, eben ausgebildet. Alternativ oder zusätzlich bevorzugt ist zumindest die vorstehende Oberfläche des Substrats elektrisch isolierend. Ferner bevorzugt beinhaltet das Substrat ein keramisches Material. Bevorzugter besteht das Substrat aus dem keramischen Material. Eine bevorzugte Vorrichtung beinhaltet ein LED-Modul. Eine besonders bevorzugte Vorrichtung ist ein LED-Modul. Ein LED-Modul beinhaltet grundsätzlich ein Substrat, auch Platine genannt, auf dem ein oder mehrere LED angeordnet sind. Im Rahmen der Erfindung sind mehrere LED, zumindest eine Vielzahl von LED der ersten Art und mindestens eine LED der weiteren Art, auf dem gemeinsamen Substrat angeordnet. Demnach ist das LED-Modul erfindungsgemäß in der sogenannten Chip-on-Board-Technologie ausgebildet.

### Elektrische Schaltung

Als elektrische Schaltung der erfindungsgemäßen Vorrichtung kommt jede zusammenhängende Anordnung elektrischer Leiter in Frage, welche dem Fachmann im Zusammenhang mit der Erfindung geeignet erscheint. Als elektrische Leiter kommen hierbei sowohl elektrische als auch elektronische Elemente in Frage.

Zu den elektrischen Leitern gehören insbesondere die lichtemittierenden Halbleiterbauelemente der Vorrichtung und elektrisch leitende Verbindungen. Bevorzugte elektrisch leitende Verbindungen sind hierbei Leiterbahnen und Drähte. Bevorzugte Leiterbahnen sind gedruckte Leiterbahnen. Bevorzugte Drähte sind Bonddrähte. Die elektrische Schaltung der erfindungsgemäßen Vorrichtung beinhaltet Parallelschaltpfade. Hierbei handelt es sich um Wege in der elektrischen Schaltung, welche zumindest abschnittsweise parallel zueinander geschaltet sind. Hierzu müssen diese Wege nicht zwingend geometrisch parallel verlaufen. Vielmehr sind die Parallelschaltpfade jedes Abschnitts des Stromkrieses untereinander parallel geschaltet, bevorzugt sind jedoch nicht alle Parallelschaltpfade eines Abschnitts zu allen Parallelschaltpfaden eines anderen Abschnitts der elektrischen Schaltung parallel geschaltet. Vielmehr beinhaltet vorzugsweise jeder weitere Abschnitt einen Parallelschaltpfad, der zu einem der Parallelschaltpfade des ersten Abschnitts in Reihe geschaltet ist. Die Parallelschaltpfade ein und desselben Abschnitts können einander überlappen. Dies bedeutet, dass ein Leiter zu mehreren Parallelschaltpfaden gehören kann. Hier können also mehrere Parallelschaltpfade eines Abschnitts in einem Weg zusammenlaufen, beispielsweise in einem Längsbalken einer doppel-T-förmigen Leiterbahn. In diesem Fall wird jeder Zweig als Parallelschaltpfad bezeichnet. Die elektrische Schaltung der erfindungsgemäßen Vorrichtung beinhaltet vorzugsweise den ersten Abschnitte und mindestens einen, bevorzugt mindestens 2, bevorzugter mindestens 3, noch bevorzugter mindestens 4, weitere Abschnitte auf. Der erste und der mindestens eine weitere Abschnitt sind vorzugsweis im Wesentlichen identisch aufgebaut. Dies bedeutet, dass die vorgenannten Abschnitte hinsichtlich der Auswahl ihrer elektrischen Komponenten und deren Verschaltung identisch sind, wobei sich die Abschnitte durch das Vorhandensein bzw. Fehlen von elektrischen Kontakten zum Anschließen weiterer Elemente, wie Beispielsweise einer Spannungsquelle, in bestimmten Abschnitten unterscheiden können. Die elektrische Schaltung der Vorrichtung ist auf dem Substrat angeordnet, das heißt die elektrische Schaltung überlagert das Substrat. Bevorzugt grenzt die elektrische Schaltung an eine Oberfläche des Substrats an. Alternativ oder zusätzlich bevorzugt ist die elektrische Schaltung mit dem Substrat verbunden.

### Betriebsspannung

Die Betriebsspannung ist nach VDE 0100-200 die jeweils örtlich zwischen den Leitern eines elektrischen Betriebsmittels herrschende Spannung. Im Gegensatz zur Nennspannung, welche sich auf die Auslegung seitens des Herstellers bezieht, beschreibt die Betriebsspannung diejenige Spannung, mit der das Betriebsmittel tatsächlich betrieben wird. Lässt ein lichtemittierendes Halbleiterbauelement elektrischen Strom nur in einer Richtung durch, wird diese Richtung als Vorwärtsrichtung bezeichnet. In diesem Fall wir das lichtemittierende Halbleiterbauelement durch Anlegen seiner Betriebsspannung in der Vorwärtsrichtung betrieben, das heißt bei Anlagen dieser Vorwärtsspannung emittiert das lichtemittierende Halbleiterbauelement Licht. Dies trifft vorzugsweise für LED zu. Als Betriebsspannung ist hierin eine Vorwärtsspannung bevorzugt. Ferner ist eine bevorzugte Betriebsspannungssumme eine Vorwärtsspannungssumme.

### Lichtquelle

Als Lichtquelle kommt im Rahmen der Erfindung jede zum Emittieren elektromagnetischer Strahlung mittels der lichtemittierenden Halbleiterbauelemente der erfindungsgemäßen Vorrichtung ausgebildete Vorrichtung, die dem Fachmann für den erfindungsgemäßen Einsatz, vorzugsweise zum Einsatz in einer Druckmaschine, geeignet erscheint, in Frage. Bevorzugt ist die Lichtquelle eine elektrische Lichtquelle. Zusätzlich oder alternativ bevorzugt ist die Lichtquelle ein Leuchtmittel oder eine Leuchte. Eine Leuchte ist eine Vorrichtung, in die ein Leuchtmittel fest eingebaut ist oder eingebaut werden kann und die zur Beleuchtung dient.

Hierbei beinhaltet das Leuchtmittel der Leuchte vorzugsweise die erfindungsgemäße Vorrichtung. Der Begriff der Beleuchtung ist hier weit zu verstehen, so dass jede Art der gezielten Bestrahlung mit elektromagnetischer Strahlung, insbesondere für industrielle Anwendungen, darunter fällt. Ein bevorzugtes Leuchtmittel ist ein LED-Leuchtmittel. Eine bevorzugte Leuchte ist eine LED-Leuchte. Die Lichtquelle beinhaltet ferner bevorzugt ein Vorschaltgerät, welches zum Betreiben eines LED-Moduls angeordnet und ausgebildet ist. Ein bevorzugtes Vorschaltgerät ist ein LED-Treiber. Die Lichtquelle beinhaltet bevorzugt ein Gehäuse, welches die erfindungsgemäße Vorrichtung teilweise umgibt. Ferner beinhaltet die Lichtquelle bevorzugt ein Emissionsfenster, das auf einer der elektrischen Schaltung zugewandten Seite des Substrats angeordnet ist. Das Emissionsfenster besteht vorzugsweise aus einem Quarzglas. Weiter bevorzugt beinhaltet die Lichtquelle Mittel zur Kühlung der Lichtquelle. Ein bevorzugtes Mittel zur Kühlung sind Kühlkanäle zum Leiten eines Kühlfluids oder eine Kühlstruktur oder beides. Eine bevorzugte Kühlstruktur beinhaltet eines, ausgewählt aus der Gruppe, bestehend aus Lamellen, Kühlrippen, Poren, und Kanälen, oder eine Kombination aus mindestens zwei davon. Kühlrippen werden auch als Kühlfinnen bezeichnet. Als Kühlfluid kommt jedes dem Fachmann im Rahmen der Erfindung, insbesondere zum Kühlen der erfindungsgemäßen Lichtquelle, geeignet erscheinende Fluid in Frage. Ein Fluid ist hierin ein fließfähiges Medium. Hierzu gehören insbesondere Gase und Flüssigkeiten. Als Kühlfluid ist hierin eine Kühlflüssigkeit bevorzugt. Eine bevorzugte Kühlflüssigkeit beinhaltet Wasser oder Glykol oder eine Mischung aus beiden. Bevorzugt besteht die Kühlflüssigkeit aus Wasser oder einem Wasser-Glykol-Gemisch.

### Überlagern

Wird hierin definiert, dass ein Element, beispielsweise eine Schicht oder ein Bauteil, ein anderes Element überlagert, so können diese Elemente unmittelbar, das heißt ohne dazwischenliegendes weiteres Element, aufeinanderfolgen oder mittelbar, das heißt mit mindestens einem dazwischenliegenden weiteren Element. Unmittelbar aufeinanderfolgende Elemente grenzen bevorzugt aneinander an, das heißt, dass sie miteinander kontaktiert sind. Ferner sind einander überlagernde Elemente vorzugsweise miteinander verbunden. Einander überlagernde Elemente können mittelbar oder unmittelbar miteinander verbunden sein. Zwei Elemente sind miteinander verbunden, wenn ihre Haftung aneinander über Van-der-Waals-Anziehungskräfte hinausgeht. Miteinander verbundene Elemente sind bevorzugt eines ausgewählt aus der Gruppe bestehend aus miteinander verlötet, verschweißt, versintert, verschraubt, und miteinander verklebt, oder eine Kombination aus mindestens zwei davon. Eine Formulierung, in der eine Schichtfolge aufgezählte Schichten oder Beschichtungen beinhaltet, bedeutet, dass zumindest die angegebenen Schichten oder Beschichtungen in der angegebenen Reihenfolge vorliegen. Diese Formulierung besagt nicht zwingend, dass diese Schichten oder Beschichtungen unmittelbar aufeinander folgen. Eine Formulierung, in der zwei Schichten aneinander angrenzen, besagt, dass diese beiden Schichten unmittelbar und somit ohne Zwischenschicht aufeinanderfolgen. Überlagert in einer Schichtfolge eine Schicht eine andere Schicht, so überlagert die Schicht die andere Schicht nicht zwingend über die gesamte Fläche der einen oder anderen Schicht, jedoch vorzugsweise über einen flächigen Bereich der beiden Schichten. Die die Schichtfolge bildenden Schichten des flächenförmigen Verbunds sind bevorzugt flächig miteinander verbunden.

### Härten

Das Härten einer Zusammensetzung ist hierin ein Verfestigen der Zusammensetzung, wobei aus der Zusammensetzung eine Schicht erhalten wird, welche bei dem Härten bevorzugt auch mit dem darunterliegenden Objekt verbunden wird. Bei der Schicht kann es sich um eine zusammenhängende Schicht handeln, was im Fall eines Lacks als Zusammensetzung bevorzugt ist, oder um eine nicht zusammenhängende Schicht, beispielsweise in Form von aus einer Druckfarbe gebildeten Buchstaben. Ein bevorzugtes Härten ist ein physikalisches Härten oder ein chemisches Härten oder beides. Ein bevorzugtes physikalisches Härten ist ein Trocknen. Ein Trocknen beinhaltet vorzugsweise ein Verringern eines Anteils eines Vehikels in der Zusammensetzung, vorzugsweise auf 0 Gew.-%, bevorzugt durch Verdampfen des Vehikels. Ein bevorzugtes Vehikel ist ein organisches Vehikel oder ein anorganisches Vehikel. Als anorganisches Vehikel ist Wasser bevorzugt. Ein weiteres bevorzugtes Vehikel ist ein Lösemittel. Ein chemisches Härten beinhaltet eine chemische Reaktion. Eine bevorzugte chemische Reaktion ist eine Polymerisationsreaktion oder eine Vernetzungsreaktion oder beides. Handelt es sich bei der Zusammensetzung um eine pulverförmige Zusammensetzung beinhaltet das Härten ein Verbinden von Partikeln der pulverförmigen Zusammensetzung unter Erhalt eines zusammenhängenden Festkörpers, welcher bevorzugt zudem mit dem darunterliegenden Objekt verbunden ist. Im Fall einer flüssigen Zusammensetzung geht diese bei dem Härten von dem flüssigen Zustand in den festen Zustand über.

### Druckträger

Als Druckträger, auch Bedruckstoff genannt, kommt jedes dem Fachmann im Rahmender Erfindung geeignet erscheinende Objekt in Frage. Ein bevorzugter Druckträger ist flächenförmig ausgebildet. Dies bedeutet, dass eine Länge und eine Breite des Druckträgers um einen Faktor von mindestens 10, bevorzugter mindestens 100, noch bevorzugter mindestens 1000, größer sind als eine Dicke des Druckträgers. Ein bevorzugter flächenförmiger Druckträger ist bahnförmig ausgebildet. Dies bedeutet, dass eine Länge des Druckträgers um einen Faktor von mindestens 2, bevorzugter mindestens 5, noch bevorzugter mindestens 10, am bevorzugtesten mindestens 100, größer sind als eine Breite des Druckträgers. Ein bevorzugter Druckträger beinhaltet, bevorzugt besteht aus, Papier, ein Folie oder ein Laminat. Ein bevorzugtes Laminat beinhaltet eine oder mehrere Polymerschichten, eine oder mehrere Papierschichten, eine oder mehrere Metallschichten, oder eine Kombination der vorgenannten Schichten in einer Schichtfolge.

### Druckfarbe

Druckfarben sind farbmittelhaltige Gemische, die eine geeignete Viskosität zu einem Auftragen als dünne Schicht haben. Hierbei hat die dünne Schicht in ausgehärtetem Zustand bevorzugt eine Dicke (Trockendicke) in einem Bereich von 0,5 bis 50 µm, bevorzugt von 1 bis 30 µm, bevorzugter von 1 bis 20 µm. Eine bevorzugte Druckfarbe beinhaltet eines, ausgewählt aus der Gruppe, bestehend aus einem oder mehreren Farbmitteln, einem Bindemittel, einer Vehikel, und einem Additiv, oder eine Kombination aus mindestens zwei, bevorzugt alle, der Vorgenannten. Ein bevorzugtes Bindemittel ist hierbei ein Harz oder ein Polymer oder eine Mischung aus beiden. Ein bevorzugtes Vehikel ist ein Lösungsmittel. Ein bevorzugtes Additiv dient zu einem Einstellen einer gewünschten Eigenschaft der Druckfarbe, bevorzugt einer gewünschten Verarbeitungseigenschaft, beispielsweise einer Viskosität der Druckfarbe. Ein bevorzugtes Additiv ist eines, ausgewählt aus der Gruppe, bestehend aus einem Dispergieradditiv, einem Entschäumer, einem Wachs, einem Gleitmittel, und einem Substratnetzmittel, oder eine Kombination aus mindestens zwei davon. Ferner ist eine bevorzugte Druckfarbe eine, ausgewählt aus der Gruppe, bestehend aus einem Toner, einer Tinte für einen Tintenstrahldrucker, einer Offset-druckfarbe, einer Illustrationsdruckfarbe, einer Flüssigfarbe, und einer strahlenhärtendes Druckfarbe, oder eine Kombination aus mindestens zwei davon. Eine bevorzugte Offset-Druckfarbe ist eine Rollenoffset-Druckfarbe oder eine Bogenoffset-Druckfarbe oder beides. Eine bevorzugte Rollenoffset-Druckfarbe ist eine Rollenoffset-Coldsetdruckfarbe oder eine Rollenoffset-Heatsetdruckfarbe oder beides. Eine bevorzugte Flüssigfarbe ist eine wasserbasierte Flüssigfarbe oder eine lösemittelbasierte Flüssigfarbe oder beides. Eine besonders bevorzugte Druckfarbe beinhaltet zu 8 bis 15 Gew.-% mindestens ein Farbmittel, bevorzugt mindestens ein Pigmet, und zu insgesamt 25 bis 40 Gew.-% mindestens ein Harz oder mindestens ein Polymer oder eine Mischung der beiden, zu 30 bis 45 Gew.-% mindestens ein hochsiedendes Mineralöl (Siedebereich 250 bis 210 °C), und zu insgesamt 2 bis 8 Gew.-% mindestens ein Additiv, jeweils bezogen auf das Gewicht der Druckfarbe.

### Lack

Ein Lack ist ein flüssiger oder auch pulverförmiger Beschichtungsstoff, der eine geeignete Viskosität zu einem Auftragen als dünne Schicht hat und aus dem durch ein Härten ein fester, vorzugsweise zusammenhängender, Film erhältlich ist. Lacke beinhalten oftmals mindestens eines, ausgewählt aus der Gruppe, bestehend aus mindestens einem Bindemittel, mindestens einem Füllstoff, mindestens einem Vehikel, mindestens einem Farbmittel, mindestens einem Harz und/oder mindestens einem Acrylat, und mindestens einem Additiv, oder eine Kombination aus mindestens zwei davon, wobei eine Kombination aller vorgenannten Bestandteile (mit Harz und/oder Acrylat) bevorzugt ist. Ein bevorzugtes Additiv ist hierbei ein Biozid. Ein bevorzugtes Biozid ist ein Topf-Konservierer. Lacke dienen oftmals zum Schutz des damit versehenen Objekts, der Dekoration, eine Funktionalisierung einer Oberfläche des Objekts, beispielsweise einer Veränderung elektrischer Eigenschaften oder einer Beständigkeit gegen Abrieb, oder einer Kombination der vorgenannten Funktionen. Ein im Rahmen der Erfindung bevorzugter Lack ist einer, ausgewählt aus der Gruppe, bestehend aus einem wasserbasierten Lack, einem lösemittelbasierten Lack, einem UV-basierten, also UV-härtbaren, Lack, und einem Dispersionslack, oder eine Kombination aus mindestens zwei davon. Ein besonders bevorzugter Lack ist zum Schutz einer bedruckten Oberfläche ausgebildet.

### Farbmittel

Als Farbmittel kommen dem Fachmann bekannte und für die vorliegende Erfindung geeignete sowohl feste und flüssige in Betracht. Farbmittel ist nach DIN 55943:2001-10 die Sammelbezeichnung für alle farbgebenden Stoffe, insbesondere für Farbstoffe und Pigmente. Ein bevorzugtes Farbmittel ist ein Pigment. Ein bevorzugtes Pigment ist ein organisches Pigment. Im Zusammenhang mit der Erfindung beachtliche Pigmente sind insbesondere die in der DIN 55943:2001-10 und die in "Industrial Organic Pigments, Third Edition." (Willy Herbst, Klaus Hunger Copyright © 2004 WILEY-VCH Verlag GmbH & Co. KGaA, Weinheim ISBN: 3-527-30576-9) erwähnten Pigmente. Ein Pigment ist ein Farbmittel, das bevorzugt in dem Anwendungsmedium unlöslich ist. Ein Farbstoff ist ein Farbmittel, das bevorzugt in dem Anwendungsmedium löslich ist.

### Verfahrensschritte

In einem hierin beschriebenen Verfahren erfolgen die Verfahrensschritte einer Schrittfolge in der angegebenen Reihenfolge ihrer Ordnungszeichen. Dabei können die Schritte einer Schrittfolge mittelbar oder unmittelbar aufeinander folgen. Ferner können aufeinanderfolgende Verfahrensschritte zeitlich nacheinander, in zeitlichem Überlapp der auch gleichzeitig erfolgen.

### MESSMETHODEN

Sofern nichts anderes angegeben ist wurden die im Rahmen der Erfindung benutzt durchgeführten Messungen bei einer Umgebungstemperatur von 23°C, einem Umgebungsluftdruck von 100 kPa (0,986 atm) und einer relativen Luftfeuchtigkeit von 50 % durchgeführt.

### Betriebsspannung und Betriebsstromstärke

Die Betriebsspannung ist den Angaben des Herstellers zu entnehmen. Die Betriebsstromstärke ergibt sich aus der ebenfalls durch den Hersteller zur Verfügung gestellten Strom-Spannungskennlinie. Insbesondere für LEDs werden die Vorwärtsspannung und die Strom-Spannungskennlinie durch den Hersteller automatisiert beim sogenannten Binning, also dem Sortieren nach Güteklassen, vermessen und üblicherweise in einem Datenblatt angegeben.

### Spektrum und Halbwertsbreite

Das Spektrum wird mit einem USB2000+ Spektrometer der Firma Ocean Optics gemessen. Die Halbwertsbreiten von Intensitätsmaxima werden mit einer geeigneten Auswertungssoftware, vorzugsweise der zum Gerät zugehörigen Software, ermittelt.

Die Erfindung wird im Folgenden durch Beispiele und Zeichnungen genauer dargestellt, wobei die Beispiele und Zeichnungen keine Einschränkung der Erfindung bedeuten. Ferner sind die Zeichnungen sofern nicht anders angegeben nicht maßstabsgetreu.

Es zeigen jeweils sofern nicht anders in der Beschreibung oder der jeweiligen Figur angegeben schematisch und nicht maßstabsgetreu:
- Figur 1: eine schematische Darstellung einer erfindungsgemäßen Vorrichtung;
- Figur 2: eine schematische Darstellung einer weiteren erfindungsgemäßen Vorrichtung;
- Figur 3a): eine schematische Darstellung einer weiteren erfindungsgemäßen Vorrichtung;
- Figur 3b): eine schematische Darstellung von Schaltpfaden der elektrischen Schaltung der erfindungsgemäßen Vorrichtung der Figur 3a);
- Figur 4: eine schematische Darstellung einer erfindungsgemäßen Lichtquelle
- Figur 5: eine schematische Darstellung einer erfindungsgemäßen Druckmaschine;
- Figur 6: ein Ablaufdiagramm eines erfindungsgemäßen Verfahrens zum Herstellen eines Druckerzeugnisses;
- Figur 7: eine schematische Darstellung eines erfindungsgemäßen Druckerzeugnisses;
- Figur 8: eine schematische Darstellung einer erfindungsgemäßen Anordnung; und
- Figur 9: ein Ablaufdiagramm eines erfindungsgemäßen Verfahrens zu einem Bestrahlen eines Bestrahlungsguts.

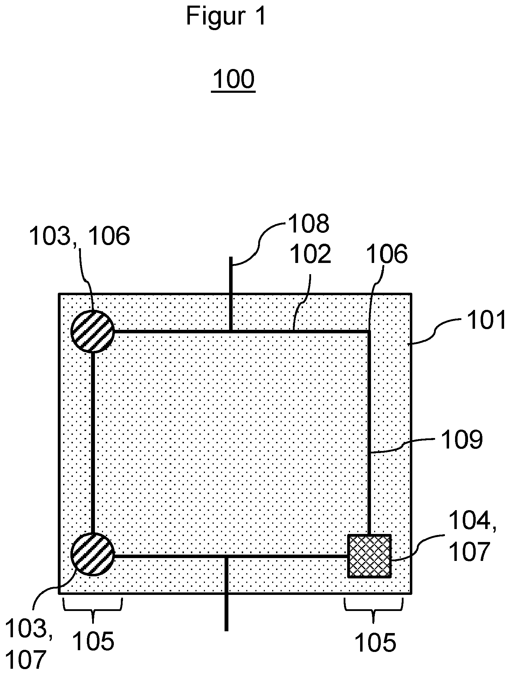

Figur 1 zeigt eine schematische Darstellung einer erfindungsgemäßen Vorrichtung 100. Diese beinhaltet ein Substrat 101 aus Aluminiumoxid. Auf dem Substrat 101 ist eine elektrische Schaltung 102 aus Leiterbahnen 109, elektrischen Kontakten zum Anschließen einer Spannungsquelle und einer ersten Vielzahl von lichtemittierenden Halbleiterbauelementen angeordnet. Die erste Vielzahl der lichtemittierenden Halbleiterbauelemente besteht hier aus 2 lichtemittierenden Halbleiterbauelementen einer ersten Art 103 und einem lichtemittierenden Halbleiterbauelement einer weiteren Art 104. Die lichtemittierende Halbleiterbauelemente der ersten Art 103 sind dazu angeordnet und ausgebildet, bei einem Anliegen einer Betriebsspannung der lichtemittierenden Halbleiterbauelemente der ersten Art 103 Licht mit einem Spektrum, beinhaltend ein lokales Intensitätsmaximum in einem ersten Wellenlängenbereich, abzustrahlen. Dem gegenüber ist das lichtemittierende Halbleiterbauelement der weiteren Art 104 dazu angeordnet und ausgebildet, bei einem Anliegen einer Betriebsspannung des lichtemittierende Halbleiterbauelements der weiteren Art 104 Licht mit einem Spektrum, beinhaltend ein lokales Intensitätsmaximum in einem von dem ersten Wellenlängenbereich verschiedenen weiteren Wellenlängenbereich abzustrahlen. Die Leiterbahnen 109 und die lichtemittierenden Halbleiterbauelemente der ersten Vielzahl sind so angeordnet, dass die elektrische Schaltung 102 2 parallel zueinander geschaltete Parallelschaltpfade 105 beinhaltet. Jeder dieser Parallelschaltpfade 105 weist ein erstes Ende 106 und ein seinem ersten Ende 106 gegenüberliegendes weiteres Ende 107 auf. Die ersten Enden 106 der beiden Parallelschaltpfade 105 sind miteinander mittels einer Leiterbahn 109 elektrisch leitend verbunden. Ferner sind die weiteren Enden 107 der beiden Parallelschaltpfade 105 elektrisch leitend mittels einer Leiterbahn 109 miteinander verbunden. Hier sind die beiden lichtemittierenden Halbleiterbauelemente der ersten Art 103 zusammen in einem der beiden Parallelschaltpfade 105 angeordnet. Das lichtemittierende Halbleiterbauelement der weiteren Art 104 ist in dem anderen Parallelschaltpfad 105 angeordnet. Jeder der beiden Parallelschaltpfade 105 zeichnet sich durch eine Betriebsspannungssumme aus, die eine Summe der Betriebsspannungen der lichtemittierenden Halbleiterbauelemente in dem jeweiligen Parallelschaltpfad 105 ist. Die beiden Betriebsspannungssummen unterscheiden sich hier um nicht mehr als 0,3 V.

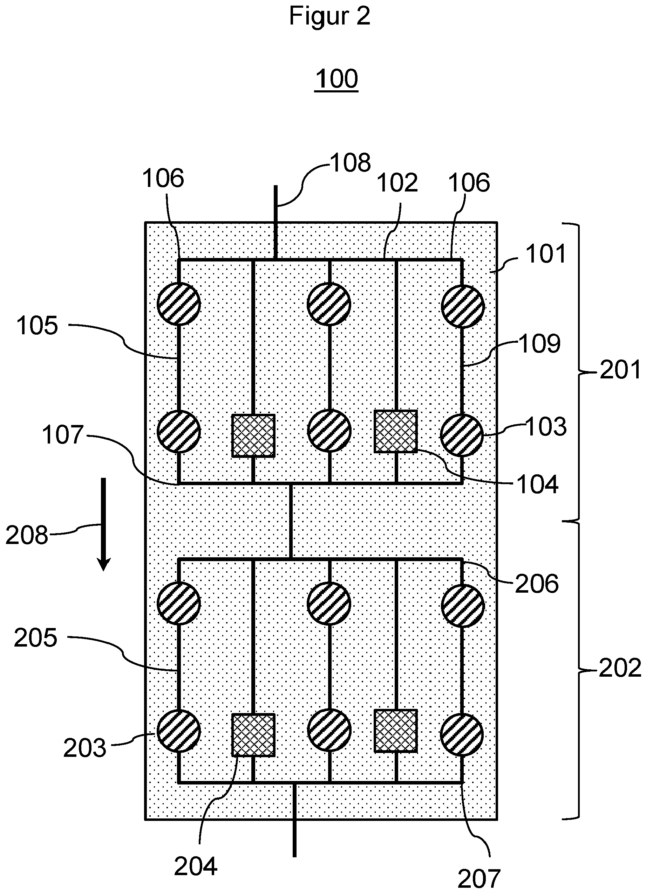

Figur 2 zeigt eine schematische Darstellung einer weiteren erfindungsgemäßen Vorrichtung 100, welche wiederum ein Substrat 101 aus einem keramischen Material, hier Aluminiumnitrid, beinhaltet. Das Substrat 101 ist eine flächenförmig ausgebildete Platine mit ebenen Oberflächen. Auf einer dieser ebenen Oberflächen ist eine elektrische Schaltung 102 unmittelbar aufgebracht. Diese elektrische Schaltung 102 beinhaltet elektrische Kontakte 108 zum Anschließen einer Spannungsquelle, gedruckte Leiterbahnen 109 sowie lichtemittierende Halbleiterbauelemente, bei denen es sich um UV-LED handelt. Die elektrische Schaltung 102 besteht aus einem ersten Abschnitt 201 und einem weiteren Abschnitt 202. Diese beiden Abschnitte 201, 202 sind, abgesehen von der spiegelverkehrten Anordnung der elektrischen Kontakte 108 und einer die beiden Abschnitte 201, 202 elektrisch leitend verbindenden Leiterbahn 109, identisch. Von den lichtemittierenden Halbleiterbauelementen der Vorrichtung 100 beinhaltet der erste Abschnitt 201 eine erste Vielzahl der lichtemittierenden Halbleiterbauelemente und der weitere Abschnitt 202 eine weitere Vielzahl der lichtemittierenden Halbleiterbauelemente. Die erste Vielzahl der lichtemittierenden Halbleiterbauelemente besteht aus 6 lichtemittierenden Halbleiterbauelementen einer ersten Art 103 und 2 lichtemittierenden Halbleiterbauelementen einer weiteren Art 104. Folglich besteht auch die weitere Vielzahl der lichtemittierenden Halbleiterbauelemente aus 6 lichtemittierenden Halbleiterbauelementen der ersten Art 203 und 2 lichtemittierenden Halbleiterbauelementen der weiteren Art 204. Die lichtemittierende Halbleiterbauelemente der ersten Art 103, 203 sind UV-A-LED mit jeweils einem Intensitätsmaximum ihres Emissionsspektrums bei 365 nm. Die UV-A-LED sind von einer Binningklasse, welche eine Betriebsspannung in einem Bereich von 3,3 bis 3,4 V definiert. Bei den lichtemittierenden Halbleiterbauelementen der weiteren Art 104, 204 handelt es sich um UV-C-LED mit jeweils einem Intensitätsmaximum ihres Emissionsspektrums bei 250 nm. Ferner definiert eine Binningklasse der UV-C-LED eine Betriebsspannung in einem Bereich von 6,7 bis 6,8 V. Ferner ist jede UV-LED der Vorrichtung 100 durch eine Vorwärtsrichtung 208 gekennzeichnet. Diese ist in der Figur durch einen Pfeil wiedergegeben. Der erste Abschnitt 201 und der weitere Abschnitt 202 der elektrischen Schaltung 102 beinhalten jeweils 5 parallel zueinander geschaltete Parallelschaltpfade 105 bzw. 205. Jeder Parallelschaltpfad 105 des ersten Abschnitts 201 weist ein erstes Ende 106 und ein seinem ersten Ende 106 in der Vorwärtsrichtung 208 gegenüberliegendes weiteres Ende 107 auf. Auch jeder Parallelschaltpfad 205 des weiteren Abschnitts 202 weist ein erstes Ende 206 und ein seinem ersten Ende 206 in der Vorwärtsrichtung 208 gegenüberliegendes weiteres Ende 207 auf. Die ersten Enden 106 der Parallelschaltpfade 105 des ersten Abschnitts 201 sind miteinander mittels einer Leiterbahn 109 elektrisch leitend verbunden. Ferner sind die weiteren Enden 107 der 5 Parallelschaltpfade 105 des ersten Abschnitts 201elektrisch leitend mittels einer Leiterbahn 109 miteinander verbunden. Gleiches gilt analog für die ersten Enden 206 und die weiteren Enden 207 der Parallelschaltpfade 205 des weiteren Abschnitts 202. Jeder der Parallelschaltpfade 105, 205 zeichnet sich durch eine Betriebsspannungssumme aus, die eine Summe der Betriebsspannungen der UV-LED in dem jeweiligen Parallelschaltpfad 105, 205 ist. Die Betriebsspannungssummen der Parallelschaltpfade 105 des ersten Abschnitts 201 unterscheiden sich um nicht mehr als 0,2 V voneinander. Gleiches gilt für die Betriebsspannungssummen der Parallelschaltpfade 205 des weiteren Abschnitts 202. Dies erlaubt es insbesondere, die UV-A-LED und die UV-C-LED in der elektrischen Schaltung 102 zusammen auf dem einstückig ausgebildeten Substrat 101 zu betreiben. Hierdurch wird ein speziell auf eine bestimmte UV-härtbare Druckfarbe angepasstes Emissionsspektrum ermöglicht und gleichzeitig können Streifen und Stufen in einer Intensitätsverteilung auf einer Bestrahlungsfläche vermieden werden. Ferner ist keine der UV-LED eines Parallelschaltpfads 105 des ersten Abschnitts 201 mit einer UV-LED eines von diesem verschiedenen Parallelschaltpfads 105 des ersten Abschnitts 201 in Reihe geschaltet. Analog dazu ist keine der UV-LED eines Parallelschaltpfads 205 des weiteren Abschnitts 202 mit einer UV-LED eines von diesem verschiedenen Parallelschaltpfads 205 des weiteren Abschnitts 202 in Reihe geschaltet. Dies vermindert eine Störanfälligkeit der Vorrichtung 100, insbesondere in dem Fall eines Ausfalls einzelner UV-LED. Sollte eine einzelne UV-LED ausfallen, wird die Anzahl zwangsläufig mitausfallender UV-LED begrenzt. In der Folge muss die Vorrichtung 100 beim Ausfall einzelner UV-LED oftmals nicht zwingend gewartet oder ausgetauscht werden, sondern kann noch weiter betrieben werden. Dies erhöht eine Lebensdauer der Vorrichtung 100.

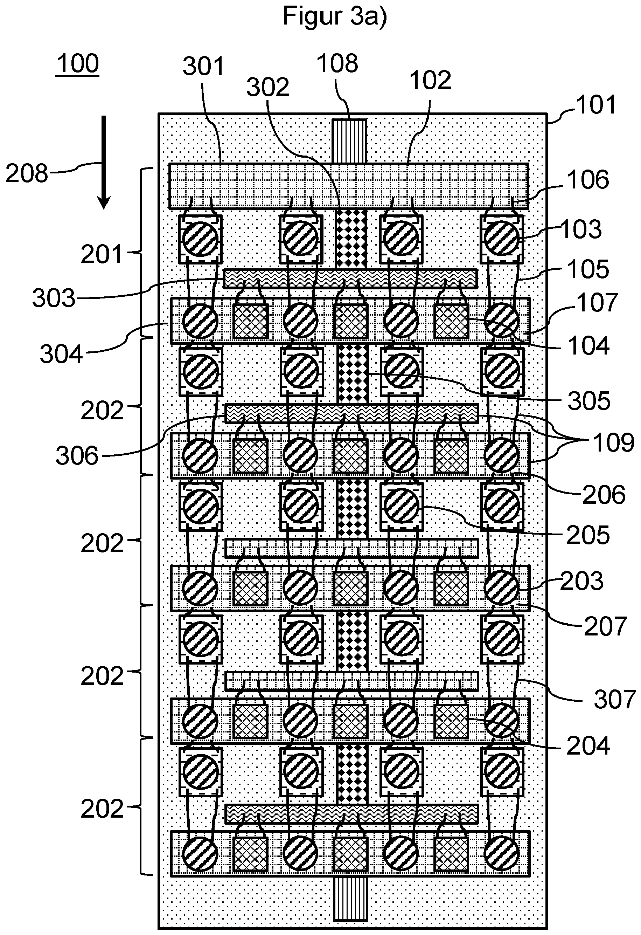

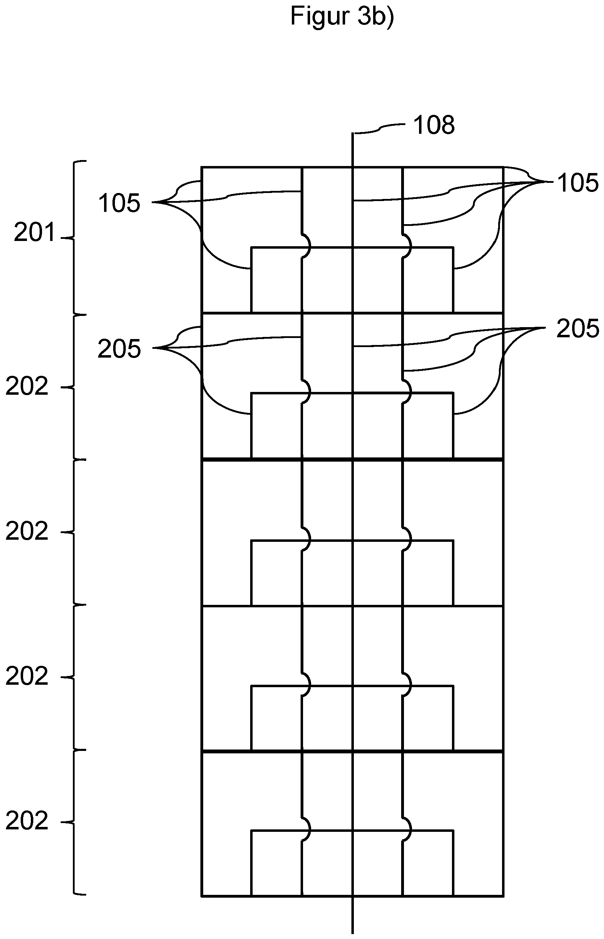

Figur 3a) zeigt eine schematische Darstellung einer weiteren erfindungsgemäßen Vorrichtung 100. Ein Substrat 101 der Vorrichtung 100 besteht aus Aluminiumoxid. Das Substrat 101 ist eine flächenförmig und einstückig ausgebildete Platine mit ebenen Oberflächen. Auf einer dieser ebenen Oberflächen ist eine elektrische Schaltung 102 unmittelbar aufgebracht. Diese elektrische Schaltung 102 beinhaltet elektrische Kontakte 108 zum Anschließen einer Spannungsquelle, Leiterbahnen 109 sowie lichtemittierende Halbleiterbauelemente, bei denen es sich um UV-LED handelt. Die elektrische Schaltung 102 besteht aus einem ersten Abschnitt 201 und 4 weiteren Abschnitten 202. Von den lichtemittierenden Halbleiterbauelementen der Vorrichtung 100 beinhaltet der erste Abschnitt 201 eine erste Vielzahl der lichtemittierenden Halbleiterbauelemente und jeder der weiteren Abschnitte 202 eine weitere Vielzahl der lichtemittierenden Halbleiterbauelemente. Die erste Vielzahl der lichtemittierenden Halbleiterbauelemente besteht aus 8 lichtemittierenden Halbleiterbauelementen einer ersten Art 103 und 3 lichtemittierenden Halbleiterbauelementen einer weiteren Art 104. Ferner besteht auch jede weitere Vielzahl der lichtemittierenden Halbleiterbauelemente aus 8 lichtemittierenden Halbleiterbauelementen der ersten Art 203 und 3 lichtemittierenden Halbleiterbauelementen der weiteren Art 204. Die lichtemittierende Halbleiterbauelemente der ersten Art 103, 203 sind UV-A-LED mit einer Betriebsspannung von etwa 3,3 V. Bei den lichtemittierenden Halbleiterbauelementen der weiteren Art 104, 204 handelt es sich um UV-C-LED mit jeweils einer Betriebsspannung von etwa 6,6 V. Ferner ist jede UV-LED der Vorrichtung 100 durch eine Vorwärtsrichtung 208 gekennzeichnet. Diese ist in der Figur durch einen Pfeil wiedergegeben. Die Leiterbahnen 109 der elektrischen Schaltung 102 beinhalten 5 doppel-T-förmige Leiterbahnen. Jede dieser doppel-T-förmige Leiterbahnen besteht aus einem ersten Querbalken, einem weiteren Querbalken und einem den ersten Querbalken mit dem weiteren Querbalken elektrisch verbindendenden Längsbalken. Hierbei grenzen der erste Querbalken, der Längsbalken und der weitere Querbalken jeder doppel-T-förmige Leiterbahn in dieser Reihenfolge in der Vorwärtsrichtung 208 aneinander an. Weitere Leiterbahnen 109 der Vorrichtung 100 sind Bonddrähte 307. Der erste Abschnitt 201 der elektrischen Schaltung 102 beinhaltet 7 parallel zueinander geschaltete Parallelschaltpfade 105 (vgl. Figur 3b)). Auch jeder weitere Abschnitt 202 der elektrischen Schaltung 102 beinhaltet 7 parallel zueinander geschaltete Parallelschaltpfade 205 (vgl. Figur 3b)). Jeder Parallelschaltpfad 105 des ersten Abschnitts 201 weist ein erstes Ende 106 und ein seinem ersten Ende 106 in der Vorwärtsrichtung 208 gegenüberliegendes weiteres Ende 107 auf. Auch jeder Parallelschaltpfad 205 jedes weiteren Abschnitts 202 weist ein erstes Ende 206 und ein seinem ersten Ende 206 in der Vorwärtsrichtung 208 gegenüberliegendes weiteres Ende 207 auf. Die ersten Enden 106 der Parallelschaltpfade 105 des ersten Abschnitts 201 sind mittels des ersten Querbalkens 301 einer ersten doppel-T-förmigen Leiterbahn miteinander elektrisch leitend verbunden. Ferner sind die weiteren Enden 107 der 7 Parallelschaltpfade 105 des ersten Abschnitts 201elektrisch leitend mittels eines ersten Querbalkens 304 einer weiteren doppel-T-förmigen Leiterbahn miteinander verbunden. Analog dazu sind auch jeweils die ersten Enden 206 und die weiteren Enden 207 der Parallelschaltpfade jedes weiteren Abschnitts 202 mittels eines ersten Querbalkens 304 einer weiteren doppel-T-förmigen Leiterbahn miteinander verbunden. In jedem der Abschnitte 201, 202 sind je 2 der insgesamt 8 UV-A-LED gemeinsam in einem der 7 Parallelschaltpfade 105, 205 angeordnet während eine der insgesamt 3 UV-C-LED in je einem der anderen der 7 Parallelschaltpfade 105, 205 angeordnet ist. Die 8 UV-A-LED eines Abschnitts 201, 202 beinhalten je 2 UV-A-LED gleichen Emissionsspektrums, wobei sich die Emissionsspektren der UV-A-LED ansonsten voneinander unterscheiden. So haben 2 der 8 UV-A-LED eines Abschnitts 201, 202 ein Emissionsspektrum mit einem lokalen Intensitätsmaximum bei 365 nm, 2 andere der UV-A-LED ein Emissionsspektrum mit einem lokalen Intensitätsmaximum bei 385 nm, 2 andere der UV-A-LED ein Emissionsspektrum mit einem lokalen Intensitätsmaximum bei 395 nm und wiederum 2 andere der UV-A-LED ein Emissionsspektrum mit einem lokalen Intensitätsmaximum bei 405 nm. Je 2 UV-A-LED mit gleichem Emissionsspektrum sind zusammen in einem Parallelschaltpfad 105, 205 angeordnet. Die 3 UV-C-LED jedes Abschnitts 201, 202 verteilen sich zu je einer UV-C-LED in einem der 3 übrigen Parallelschaltpfade 105, 205 des Abschnitts 201, 202. Diese 3 übrigen Parallelschaltpfade 105, 205 jedes Abschnitts 201, 202 überlappen in einem Längsbalken 302, 305 einer doppel-T-förmigen Leiterbahn miteinander. Jeder der Parallelschaltpfade 105, 205 zeichnet sich durch eine Betriebsspannungssumme aus, die eine Summe der Betriebsspannungen der UV-LED in dem jeweiligen Parallelschaltpfad 105, 205 ist. Es folgt, dass die Betriebsspannungssummen der Parallelschaltpfade 105 des ersten Abschnitts 201 sich um nicht mehr als 0,1 V voneinander unterscheiden. Gleiches gilt für die Betriebsspannungssummen der Parallelschaltpfade 205 jedes weiteren Abschnitts 202. Die vorstehend beschriebene Anordnung von UV-A-LED und UV-C-LED erlaubt es, ein Gesamtemissionsspektrum einer Lichtquelle 400 mit der Vorrichtung 100 sehr flexibel und einfach an verschiedene zu bestrahlende UV-härtbare Druckfarben oder Lacke anzupassen. Ferner ist keine der UV-LED eines Parallelschaltpfads 105 des ersten Abschnitts 201 mit einer UV-LED eines von diesem verschiedenen Parallelschaltpfads 105 des ersten Abschnitts 201 in Reihe geschaltet. Analog dazu ist keine der UV-LED eines Parallelschaltpfads 205 eines weiteren Abschnitts 202 mit einer UV-LED eines von diesem verschiedenen Parallelschaltpfads 205 desselben weiteren Abschnitts 202 in Reihe geschaltet. Dies verringert die Störanfälligkeit einer Lichtquelle 400 mit der Vorrichtung 100. Die UV-C-LED des ersten Abschnitts 201 sind mittels Bonddrähten 307 mit dem Längsbalken 302 und dem weiteren Querbalken 303 der ersten doppel-T-förmigen Leiterbahn elektrisch leitend verbunden. Ferner ist der erste Querbalken 301 der ersten doppel-T-förmigen Leiterbahn entlang jedes der Parallelschaltpfade 105 des ersten Abschnitts 201 mittels Bonddrähten 307 mit dem ersten Querbalken 304 der in der Vorwärtsrichtung 208 folgenden weiteren doppel-T-förmigen Leiterbahn elektrisch leitend verbunden. Zudem ist der weitere Querbalken 303 der ersten doppel-T-förmigen Leiterbahn entlang jedes mit UV-A-LED bestückten Parallelschaltpfads 105 der 4 Parallelschaltpfade 105 des ersten Abschnitts 201 mittels Bonddrähten 307 mit dem ersten Querbalken 304 der in der Vorwärtsrichtung 208 folgenden weiteren doppel-T-förmigen Leiterbahn elektrisch leitend verbunden. Die doppel-T-förmige Leiterbahnen sind in einem Siebdruckverfahren gedruckte Leiterbahnen. Die vorstehend beschriebene Kombination aus Bonddrähten 307 und gedruckten Leiterbahnen in der beschriebenen Anordnung der elektrischen Schaltung 102 ermöglicht es, die Vorrichtung einfach und effizient herzustellen und gestattet zudem eine Lichtquelle 400 mit der Vorrichtung 100 in einer besonders kompakten Bauweise auszuführen.

Figur 3b) zeigt eine schematische Darstellung von Schaltpfaden der elektrischen Schaltung 102 der erfindungsgemäßen Vorrichtung 100 der Figur 3a). Im Vergleich mit der Figur 3a) ist erkennbar, dass die elektrische Schaltung 102 in dem ersten Abschnitt 201 7 Parallelschaltpfade 105 und in jedem weiteren Abschnitt 202 7 Parallelschaltpfade 205 beinhaltet.

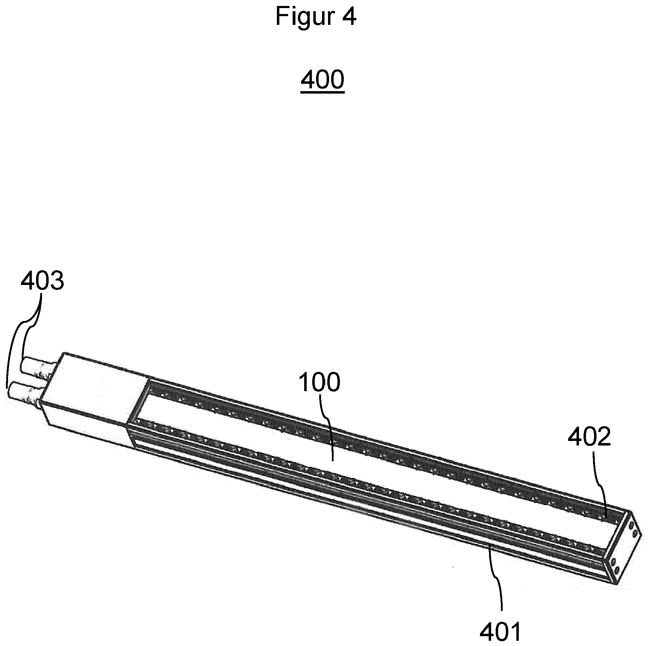

Figur 4 zeigt eine schematische Darstellung einer erfindungsgemäßen Lichtquelle 400. Diese Lichtquelle 400 ist eine UV-Leuchte der Klasse UV4000 Semray von Heraeus Noblelight GmbH, die mit einer erfindungsgemäßen Vorrichtung 100 des in Figur 3a) gezeigten Aufbaus als LED-Package nachgerüstet wurde. Die Vorrichtung ist teilweise von einem Gehäuse 401 der Vorrichtung umgeben. Ferner beinhaltet die Lichtquelle 400 ein Emissionsfenster 402 aus Quarzglas, das auf einer der elektrischen Schaltung 102 der Vorrichtung 100 zugewandten Seite des Substrats 101 angeordnet ist. Weiter beinhaltet die Lichtquelle 400 Anschlüsse 403 für einen Zulauf und einen Rücklauf eines Kühlfluids zum Kühlen der Vorrichtung 100.

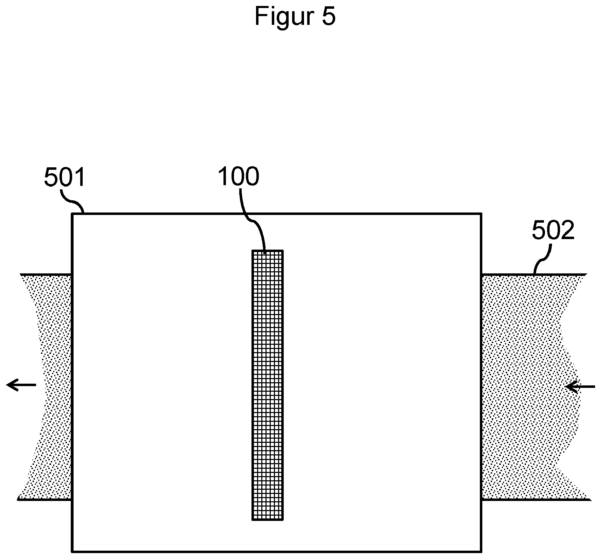

Figur 5 zeigt eine schematische Darstellung einer erfindungsgemäßen Druckmaschine 501. Die Druckmaschine 501 beinhaltet die Lichtquelle 400 der Figur 4. Die Lichtquelle 400 ist in der Druckmaschine 501 zu einem Bestrahlen einer auf einen Druckträger 502 gedruckten Zusammensetzung angeordnet. Bei der Druckmaschine 501 handelt es sich um eine Bogenoffset-Druckmaschine.

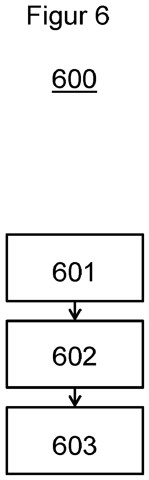

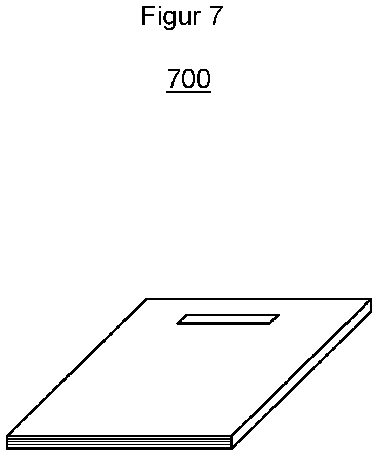

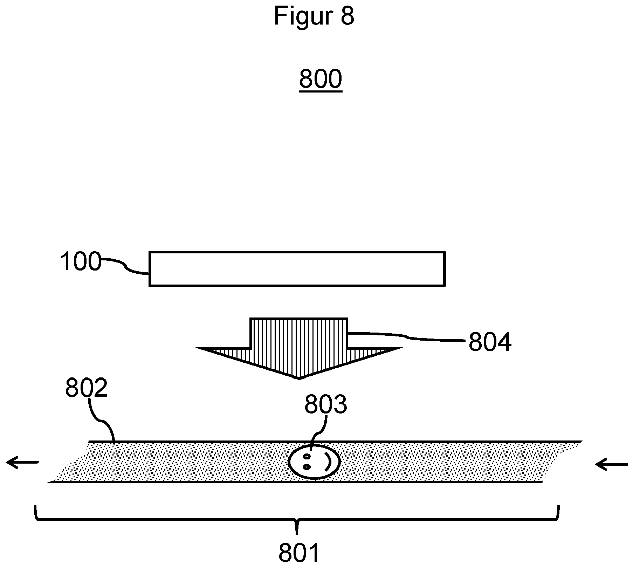

Figur 6 zeigt ein Ablaufdiagramm eines erfindungsgemäßen Verfahrens 600 zum Herstellen eines Druckerzeugnisses 700 (vgl. Figur 7). In einem Verfahrensschritt A) 601 werden die Druckmaschine 501 der Figur 5 und ein Druckträger 802 als Objekt 802 bereitgestellt (vgl. Figur 8). In einem nachfolgenden Verfahrensschritt B) 602 wird eine flüssige Zusammensetzung 803, die eine Bogenoffset-Druckfarbe ist, mit der Druckmaschine 501 auf den Druckträger 802 gedruckt. In einem Verfahrensschritt C) 603 wird die aufgedruckte Bogenoffset-Druckfarbe mit von UV-A-LED verschiedenen Emissionsspektrums und UV-C-LED der Lichtquelle 400 abgestrahltem UV-Licht 804 gleichzeitig bestrahlt und dadurch mittels Polymerisieren gehärtet. Die im Verfahrensschritt C) 603 auf dem Druckträger 802 bzw. der Bogenoffset-Druckfarbe erzeugte Intensitätsverteilung des UV-Lichts 804 ist sehr homogen und weist insbesondere keine Streifen oder Stufen auf. Zusätzlich ist ein Gesamtspektrum des UV-Lichts 804 an die Bogenoffset-Druckfarbe angepasst. Somit kann die Bogenoffset-Druckfarbe sehr effizient und über den Druckträger 802 hinweg gleichmäßig ausgehärtet werden.

Figur 7 zeigt eine schematische Darstellung eines erfindungsgemäßen Druckerzeugnisses 700. Hierbei handelt es sich um ein nach dem Verfahren 600 der Figur 8 erhältlichen Prospekt 700.

Figur 8 zeigt eine schematische Darstellung einer erfindungsgemäßen Anordnung 800. Diese umfasst die Druckmaschine 501 der Figur 5 und ein Bestrahlungsgut 801, welches aus einem Objekt 802, hier ein Druckträger 1802, und einer auf den Druckträger 802 gedruckten Druckfarbe 803 besteht. Die Lichtquelle 400 der Druckmaschine 501 und das Bestrahlungsgut 801 sind so angeordnet, dass die aufgedruckte Druckfarbe 803 mit von den UV-LED der Lichtquelle 400 abgestrahltem UV-Licht 804 bestrahlt werden kann.

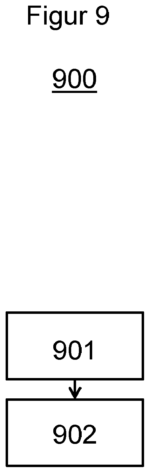

Figur 9 zeigt ein Ablaufdiagramm eines erfindungsgemäßen Verfahrens 900 zu einem Bestrahlen eines Bestrahlungsguts 801. In einem Verfahrensschritt A] 901 wird die Anordnung 800 der Figur 8 bereitgestellt. In einem Verfahrensschritt B] 802 wird das Bestrahlungsgut 801 mit von UV-A-LED verschiedenen Emissionsspektrums und UV-C-LED der Lichtquelle 400 abgestrahltem UV-Licht 804 gleichzeitig bestrahlt.

### LISTE DER BEZUGSZEICHEN

- **100**: erfindungsgemäße Vorrichtung
- **101**: Substrat
- **102**: elektrische Schaltung
- **103**: lichtemittierendes Halbleiterbauelement erster Art der ersten Vielzahl von lichtemittierenden Halbleiterbauelemente
- **104**: lichtemittierendes Halbleiterbauelement weiterer Art der ersten Vielzahl von lichtemittierenden Halbleiterbauelemente
- **105**: Parallelschaltpfade der ersten Vielzahl von Parallelschaltpfaden
- **106**: erstes Ende eines Parallelschaltpfade der ersten Vielzahl von Parallelschaltpfaden
- **107**: weiteres Ende eines Parallelschaltpfade der ersten Vielzahl von Parallelschaltpfaden
- **108**: elektrischer Kontakt
- **109**: Leiterbahn
- **201**: erster Abschnitt
- **202**: weiterer Abschnitt
- **203**: lichtemittierendes Halbleiterbauelement erster Art der weiteren Vielzahl von lichtemittierenden Halbleiterbauelemente
- **204**: lichtemittierendes Halbleiterbauelement weiterer Art der weiteren Vielzahl von lichtemittierenden Halbleiterbauelemente
- **205**: Parallelschaltpfade der weiteren Vielzahl von Parallelschaltpfaden
- **206**: erstes Ende eines Parallelschaltpfade der weiteren Vielzahl von Parallelschaltpfaden
- **207**: weiteres Ende eines Parallelschaltpfade der weiteren Vielzahl von Parallelschaltpfaden
- **208**: Vorwärtsrichtung
- **301**: erster Querbalken der ersten doppel-T-förmigen Leiterbahn
- **302**: Längsbalken der ersten doppel-T-förmigen Leiterbahn
- **303**: weiterer Querbalken der ersten doppel-T-förmigen Leiterbahn
- **304**: erster Querbalken einer weiteren doppel-T-förmigen Leiterbahn
- **305**: Längsbalken der ersten doppel-T-förmigen Leiterbahn
- **306**: weiterer Querbalken der weiteren doppel-T-förmigen Leiterbahn
- **307**: Bonddraht
- **400**: erfindungsgemäße Lichtquelle
- **401**: Gehäuse
- **402**: Emissionsfenster
- **403**: Anschlüsse für Kühlfluid
- **501**: erfindungsgemäße Druckmaschine
- **502**: Druckträger
- **600**: erfindungsgemäßes Verfahren zum Herstellen eines Druckerzeugnisses
- **601**: Verfahrensschritt A)
- **602**: Verfahrensschritt B)
- **603**: Verfahrensschritt C)
- **700**: erfindungsgemäßes Druckerzeugnis / Prospekt
- **800**: erfindungsgemäße Anordnung
- **801**: Bestrahlungsgut
- **802**: Objekt / Druckträger
- **803**: Zusammensetzung / Druckfarbe
- **804**: UV-Licht
- **900**: erfindungsgemäßes Verfahren zu einem Bestrahlen eines Bestrahlungsguts
- **901**: Verfahrensschritt A]
- **902**: Verfahrensschritt B]

## Patentansprüche

1. Eine Vorrichtung (100), beinhaltend
a) ein Substrat (101), und
b) eine auf dem Substrat (101) angeordnete elektrische Schaltung (102), beinhaltend einen ersten Abschnitt (201), beinhaltend
i) eine erste Vielzahl von lichtemittierenden Halbleiterbauelementen, beinhaltend
A) eine Vielzahl von lichtemittierenden Halbleiterbauelementen einer ersten Art (103), und
B) mindestens ein lichtemittierendes Halbleiterbauelement einer weiteren Art (104), und
ii) eine erste Vielzahl von parallel zueinander geschalteten Parallelschaltpfaden (105);
wobei jeder der Parallelschaltpfade (105) der ersten Vielzahl von Parallelschaltpfaden (105)
a. ein erstes Ende (106), und
b. ein gegenüberliegendes weiteres Ende (107)
beinhaltet;
wobei die ersten Enden (106) der Parallelschaltpfade (105) der ersten Vielzahl von Parallelschaltpfaden (105) miteinander elektrisch leitend verbunden sind;
wobei die weiteren Enden (107) der Parallelschaltpfade (105) der ersten Vielzahl von Parallelschaltpfaden (105) elektrisch leitend miteinander verbunden sind;
wobei jedes lichtemittierende Halbleiterbauelement der ersten Art (103) dazu angeordnet und ausgebildet ist, bei einem Anliegen einer Betriebsspannung des lichtemittierende Halbleiterbauelements der ersten Art (103) Licht mit einem Spektrum, beinhaltend ein lokales Intensitätsmaximum in einem ersten Wellenlängenbereich, abzustrahlen, wobei jedes lichtemittierende Halbleiterbauelement der weiteren Art (104) dazu angeordnet und ausgebildet ist, bei einem Anliegen einer Betriebsspannung des lichtemittierende Halbleiterbauelements der weiteren Art (104) Licht mit einem Spektrum, beinhaltend ein lokales Intensitätsmaximum in einem von dem ersten Wellenlängenbereich verschiedenen weiteren Wellenlängenbereich abzustrahlen;
wobei mindestens einer der Parallelschaltpfade (105) der ersten Vielzahl von Parallelschaltpfaden (105) ein lichtemittierendes Halbleiterbauelementen der weiteren Art (104) beinhaltet;
wobei jeder Parallelschaltpfad (105) der ersten Vielzahl von Parallelschaltpfaden (105) **gekennzeichnet ist durch** eine Betriebsspannungssumme, die eine Summe der Betriebsspannungen der lichtemittierenden Halbleiterbauelemente in dem jeweiligen Parallelschaltpfad (105) ist;
**dadurch gekennzeichnet, dass** keine Betriebsspannungssumme der Parallelschaltpfade (105) der ersten Vielzahl von Parallelschaltpfaden (105) um mehr als 0,6 V von einer Betriebsspannungssumme der Parallelschaltpfade (105) der ersten Vielzahl von Parallelschaltpfaden (105) abweicht.

2. Die Vorrichtung (100) nach Anspruch 1, wobei
A. der erste Wellenlängenbereich sich über einen Bereich von 315 bis 450 nm erstreckt; oder
B. sich der weitere Wellenlängenbereich über einen Bereich von 280 bis weniger als 315 nm, oder über einen Bereich von 10 bis weniger als 280 nm, oder über beide Bereiche erstreckt; oder
C. beides aus A. und B.

3. Die Vorrichtung (100) nach Anspruch 1 oder 2, wobei die lichtemittierenden Halbleiterbauelemente der ersten Art (103) durch erste Betriebsspannungen gekennzeichnet sind,
wobei die lichtemittierenden Halbleiterbauelemente der weiteren Art (104) durch von den ersten Betriebsspannungen verschiedene weitere Betriebsspannungen gekennzeichnet sind.

4. Die Vorrichtung (100) nach einem der vorhergehenden Ansprüche, wobei kein lichtemittierendes Halbleiterbauelement eines Parallelschaltpfads (105) der ersten Vielzahl von Parallelschaltpfaden (105) mit einem lichtemittierenden Halbleiterbauelement eines von diesem verschiedenen Parallelschaltpfad (105) der ersten Vielzahl von Parallelschaltpfaden (105) in Reihe geschaltet ist.

5. Die Vorrichtung (100) nach einem der vorhergehenden Ansprüche, wobei die elektrische Schaltung (102) eine erste doppel-T-förmige Leiterbahn beinhaltet,
wobei die erste doppel-T-förmige Leiterbahn einen ersten Querbalken (301), einen weiteren Querbalken (303) und einen den ersten Querbalken (303) mit dem weiteren Querbalken (303) lektrisch verbindenden Längsbalken (302) beinhaltet.

6. Die Vorrichtung (100) nach einem der vorhergehenden Ansprüche, wobei die lichtemittierenden Halbleiterbauelemente der ersten Art (103) Leuchtdioden der ersten Art sind, wobei die Leuchtdioden der ersten Art UV-Leuchtdioden, insbesondere UV-A-Leuchtdioden, sind.

7. Die Vorrichtung (100) nach einem der vorhergehenden Ansprüche, wobei die lichtemittierenden Halbleiterbauelemente der weiteren Art (104) Leuchtdioden der weiteren Art sind,
wobei die Leuchtdioden der weiteren Art UV-Leuchtdioden, insbesondere UV-B-Leuchtdioden oder UV-C-Leuchtdioden oder eine Mischung dieser beiden, sind.

8. Die Vorrichtung (100) nach einem der vorhergehenden Ansprüche, wobei die lichtemittierenden Halbleiterbauelemente der ersten Vielzahl von lichtemittierenden Halbleiterbauelementen Leuchtdioden, insbesondere UV-Leuchtdioden, sind.

9. Eine Lichtquelle (400), beinhaltend die erfindungsgemäße Vorrichtung (100) nach einem der Ansprüche 1 bis 8.

10. Eine Druckmaschine (501), beinhaltend die Lichtquelle (400) nach Anspruch 9.

11. Ein Verfahren (600), beinhaltend als Verfahrensschritte
A) Bereitstellen
I) der Lichtquelle (400) nach Anspruch 9, und
II) eines Objekts;
B) Überlagern des Objekts mit einer Zusammensetzung; und
C) Bestrahlen der Zusammensetzung mit von mindestens einem Teil der lichtemittierenden Halbleiterbauelemente der ersten Vielzahl von lichtemittierenden Halbleiterbauelementen abgestrahltem Licht.

12. Das Verfahren (600) nach Anspruch 11, wobei der Verfahrensschritt C) (603) ein Härten der Zusammensetzung beinhaltet.

13. Ein Druckerzeugnis (700), erhältlich durch das Verfahren (600) nach Anspruch 11 oder 12.

14. Eine Anordnung (800), beinhaltend
a] die Lichtquelle (400) nach Anspruch 9, und
b] ein Bestrahlungsgut (801),
wobei die Lichtquelle (400) und das Bestrahlungsgut (801) zu einem Bestrahlen des Bestrahlungsguts (801) mit von mindestens einem Teil der lichtemittierenden Halbleiterbauelementen der ersten Vielzahl von lichtemittierenden Halbleiterbauelementen abgestrahltem Licht (804) angeordnet und ausgebildet sind.

15. Ein Verfahren (900), beinhaltend als Verfahrensschritte
A] Bereitstellen der Anordnung (800) nach Anspruch 14; und
B] Bestrahlen des Bestrahlungsguts (801) mit von mindestens einem Teil der lichtemittierenden Halbleiterbauelemente der ersten Vielzahl von lichtemittierenden Halbleiterbauelementen abgestrahltem Licht (804).

16. Eine Verwendung der Lichtquelle (400) nach Anspruch 9 in einer Druckmaschine (501).

17. Eine Verwendung der Lichtquelle (400) nach Anspruch 9 zu einem Härten einer Zusammensetzung.
